(19) **Europäisches Patentamt / European Patent Office / Office européen des brevets**

(11) **EP 1 852 894 A1**

(12) **EUROPEAN PATENT APPLICATION**
published in accordance with Art. 158(3) EPC

(43) Date of publication:
07.11.2007 Bulletin 2007/45

(51) Int Cl.:
*H01L 21/027* (2006.01)    *G03F 7/20* (2006.01)

(21) Application number: **06714473.3**

(22) Date of filing: **23.02.2006**

(86) International application number:
**PCT/JP2006/303333**

(87) International publication number:
**WO 2006/090807 (31.08.2006 Gazette 2006/35)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **25.02.2005 JP 2005052158**

(71) Applicant: **NIKON CORPORATION**
**Tokyo 100-8331 (JP)**

(72) Inventors:
 • **ICHIHARA, Yutaka,**
 **NIKON CORPORATION IPD**
 **Chiyoda-ku Tokyo, 100-8331 (JP)**
 • **NAKAMURA, Ayako,**
 **NIKON CORPORATION IPD**
 **Chiyoda-ku Tokyo, 100-8331 (JP)**

 • **SHIRAISHI, Naomasa,**
 **NIKON CORPORATION IPD**
 **Chiyoda-ku Tokyo, 100-8331 (JP)**
 • **TANIMOTO, Akikazu,**
 **NIKON CORPORATION IPD**
 **Chiyoda-ku Tokyo, 100-8331 (JP)**
 • **KUDO, Yuji,**
 **NIKON CORPORATION IPD**
 **Chiyoda-ku Tokyo, 100-8331 (JP)**

(74) Representative: **Hooiveld, Arjen Jan Winfried et al**
**Arnold & Siedsma**
**Sweelinckplein 1**
**2517 GK Den Haag (NL)**

(54) **EXPOSURE METHOD AND APPARATUS, AND ELECTRONIC DEVICE MANUFACTURING METHOD**

(57)    An object is to provide a high-resolution and economical exposure method suitable for use in formation of a fine pattern for making up an electronic device. Two diffraction gratings (P1, P2) are located in series in an optical path; the two diffraction gratings (P1, P2) and a wafer or the like (W) for making up an electronic device are arranged with a predetermined spacing; a light-dark pattern of interference fringes generated by the diffraction gratings (P1, P2) is transferred onto the wafer or the like (W) to effect exposure. The exposure is done while changing a positional relation between the wafer or the like (W) and the diffraction gratings (P1, P2) according to need.

Fig.1

**Description**

**Technical Field**

The present invention relates to an exposure method used in a fine pattern forming step in a process of manufacturing electronic devices such as semiconductor integrated circuits, flat panel display devices, thin-film magnetic heads, and micro machines, and an electronic device manufacturing method using the exposure method, and to an exposure apparatus and illumination optical apparatus suitable for use in the same method.

**Background Art**

The photolithography technology is generally used in a step of forming a fine pattern in the process of manufacturing the electronic devices such as the semiconductor integrated circuits. This is to form a photoresist (photosensitive thin film) on a surface of a substrate to be processed, e.g., a wafer and to perform an exposure step with exposure light having a light quantity distribution according to a shape of a pattern to be formed, a development step, an etching step, etc. to form a desired pattern on the substrate to be processed.

The projection exposure method is mainly used as an exposure method in the above-described exposure step in manufacture of the presently most-advanced electronic devices.

This is to form a fourfold or fivefold magnified pattern with respect to a pattern to be formed, on a mask (or reticle), to apply illumination light onto it, and to guide transmitted light thereof through a reduction projection optical system to transfer a reduced image of the pattern onto the wafer.

The degree of fineness of the pattern that can be formed by the projection exposure method is determined by the resolution of the reduction projection optical system and it is approximately equal to a value obtained by dividing the exposure wavelength by the numerical aperture (NA) of the projection optical system. Therefore, in order to form a finer circuit pattern, it is necessary to prepare an exposure light source of a shorter wavelength and a projection optical system of a higher NA.

On the other hand, there is also a proposal on a method of locating a diffraction grating between the light source and the substrate to be processed, such as a wafer, inducing interference on the substrate to be processed, among a plurality of diffracted light beams generated upon irradiation of the diffraction grating with illumination light, and using a light-dark pattern of interference fringes made by the interference, to form a fine pattern on the substrate to be processed (hereinafter referred to as an "interference exposure method"), for example, as disclosed in Non-patent Document 1 and Non-patent Document 2.

Non-patent Document 1: J. M. Carter et al.: "Interference Lithography" http://snl.mit.edu/project_document/SNL-8.pdf
Non-patent Document 2: Mark L. Schattenburg et al.: Grating Production Methods" http://snl.mit.edu/papers/presentations/2002/MLS-Con-X-2002-07-03.pdf

**Disclosure of the Invention**

Problems to be Solved by the Invention

In order to achieve a higher resolution, the projection exposure method among the conventional exposure methods requires the light source of a shorter wavelength and the projection optical system of a higher NA.

In the presently most-advanced exposure apparatus, however, the wavelength of the exposure light is already decreased to as short as 193 nm and it is hard to further decrease the wavelength in the future, in terms of available lens materials.

Furthermore, the NA of the presently most-advanced projection optical systems is approximately 0.92 and a further increase in NA is difficult and would largely raise manufacturing cost of the exposure apparatus.

On the other hand, in order to improve the contrast of interference fringes formed and obtain the interference fringes with high contrast in a wide range of traveling directions of the illumination light, the interference exposure method is required to provide high spatial coherence between beams to undergo interference. Furthermore, in order to ensure uniformity of illuminance of exposure light on the substrate to be exposed, it is necessary to make the illumination light applied onto the substrate to be exposed, incident thereto across a certain range of incidence angles, which contradicts the foregoing high spatial coherence, and it was thus difficult to realize the both at the same time.

The present invention has been accomplished in view of the above-described problems, and a first object of the present invention is to provide an exposure method capable of inexpensively forming a fine pattern, specifically, a fine pattern of not more than about the wavelength of the exposure light.

More specifically, a second object of the present invention is to provide a good interference exposure method by obtaining high-contract interference fringes across a wide range of traveling directions of illumination light near a substrate to be processed, while achieving a uniform illumination-light illuminance distribution in a wide region in the substrate to be processed.

Another object of the present invention is to provide an electronic device manufacturing method using the above exposure method, and also to provide an exposure apparatus and an illumination optical apparatus suitable for use in the above exposure method.

Means for Solving the Problems

A first exposure method as an aspect of the present invention is an exposure method of effecting exposure of a pattern on a photosensitive substrate with illumination light from a light source, the exposure method comprising: a step of applying the illumination light onto a first diffraction grating which has a direction of a period in a first direction and a longitudinal direction in a second direction perpendicular to the first direction; a step of applying diffracted light from the first diffraction grating, onto a second diffraction grating which is located at a first effective distance and on the opposite side to the light source from the first diffraction grating and which has a direction of a period in the first direction; and a step of applying diffracted light from the second diffraction grating, onto the photosensitive substrate located at a second effective distance substantially equal to the first effective distance and on the opposite side to the first diffraction grating from the second diffraction grating; wherein a principal component of the illumination light applied onto a predetermined point on the first diffraction grating comprises a plurality of illumination light beams having respective traveling directions substantially corresponding with a specific plane which includes the second direction and which is substantially normal to the first diffraction grating.

The first exposure method can also be arranged as follows: an effective angle of a deviation from a direction in the specific plane, of the traveling directions of the principal component of the illumination light applied onto the first diffraction grating is within 1 [mrad], as an example.

A second exposure method as another aspect of the present invention is an exposure method of effecting exposure of a pattern on a photosensitive substrate with illumination light from a light source, the exposure method comprising: a step of applying the illumination light onto a first diffraction grating which has a direction of a period in a first direction and a longitudinal direction in a second direction perpendicular to the first direction; a step of applying diffracted light from the first diffraction grating, onto a second diffraction grating which is located at a first effective distance and on the opposite side to the light source from the first diffraction grating and which has a direction of a period in the first direction; and a step of applying diffracted light from the second diffraction grating, onto the photosensitive substrate located at a second effective distance substantially equal to the first effective distance and on the opposite side to the first diffraction grating from the second diffraction grating; wherein a range of effective incidence angles of the illumination light applied onto a predetermined point on the first diffraction grating is not more than 2 [mrad] in the first direction, and is more than 2 [mrad] in the second direction.

Furthermore, the second exposure method can also be arranged as follows: the range of effective incidence angles of the illumination light applied onto the predetermined point on the first diffraction grating is not more than 1 [mrad] in the first direction, and is more than 5 [mrad] in the second direction.

Since the first exposure method and the second exposure method as the aspects of the present invention described above are arranged to optimize the effective range of incidence angles of the illumination light with respect to the period directions and the longitudinal directions of the first diffraction grating and the second diffraction grating, high-contrast or high-resolution interference fringes can be formed with a good margin on the photosensitive substrate and the exposure thereof can be effected on the photosensitive substrate.

A third exposure method as another aspect of the present invention is an exposure method of effecting exposure of a pattern on a photosensitive substrate with illumination light from a light source, the exposure method comprising: a step of applying the illumination light onto a first diffraction grating which has a direction of a period in a first direction and a longitudinal direction in a second direction perpendicular to the first direction; a step of applying diffracted light from the first diffraction grating, onto a second diffraction grating which is located at a first effective distance and on the opposite side to the light source from the first diffraction grating and which has a direction of a period in the first direction; and a step of applying diffracted light from the second diffraction grating, onto the photosensitive substrate located at a second effective distance substantially equal to the first effective distance and on the opposite side to the first diffraction grating from the second diffraction grating; wherein a diffracted light selecting member having transmittances for the diffracted light varying according to traveling directions of the diffracted light is disposed on an optical path between the first diffraction grating and the substrate.

The third exposure method can also arranged as follows, as an example: the transmittances of the diffracted light selecting member are low for the diffracted light emerging at a small angle of emergence from the first diffraction grating or from the second diffraction grating and high for the diffracted light emerging at a large angle of emergence from the first diffraction grating or from the second diffraction grating.

According to the third exposure method as the aspect of the present invention described above, the diffracted light having predetermined traveling directions can be reduced relative to the other diffracted light, among the diffracted light generated from the first diffraction grating or from the second diffraction grating and the desired diffracted light can be relatively preferentially used to form the interference fringes on the photosensitive substrate. Therefore, much preferred interference fringes with higher contrast can be formed and the exposure thereof can be effected on the photosensitive substrate.

Any one of the first exposure method, the second exposure method, and the third exposure method according to the present invention can be arranged as follows: the first diffraction grating is formed on or near a surface on the light source side of a first optically-transparent flat plate. The second diffraction grating can be one formed on or near a surface on the first diffraction grating side of a second optically-transparent flat plate.

The first effective distance and the second effective distance both can be not less than 1 mm and not more than 15 mm.

Furthermore, a difference between the first effective distance and the second effective distance can be not more than 100 $\mu$m, as an example.

Any one of the first exposure method, the second exposure method, and the third exposure method according to the present invention can be arranged as follows: at least one of the first effective distance and the second effective distance, or a difference between the first effective distance and the second effective distance is determined according to a convergence/divergence state in the first direction of the illumination light applied onto the substrate, and expansion/contraction of the substrate, or further according to a predetermined condition.

In another arrangement, the method can also be arranged as follows: a convergence/divergence state in the first direction of the illumination light applied onto the first diffraction grating is determined according to the first effective distance and the second effective distance, expansion/contraction of the substrate, or a predetermined condition.

Any one of the first exposure method, the second exposure method, and the third exposure method according to the present invention can be arranged as follows: the steps are carried out by scanning exposure to effect the exposure while causing a relative scan of the first diffraction grating and the second diffraction grating to the substrate in the second direction. Furthermore, a shape of a region where the illumination light is applied on the substrate, can be one varying in a width in the second direction, depending upon positions in the first direction.

The exposure methods can also be arranged as follows: an optical path between the second diffraction grating and the substrate is filled with a dielectric having a refractive index of not less than 1.2 at a wavelength of the exposure. In another arrangement, an optical path between the first diffraction grating and the substrate is filled with a dielectric having a refractive index of not less than 1.2 at the wavelength of the exposure.

A first electronic device manufacturing method as another aspect of the present invention is an electronic device manufacturing method wherein any one of the above-described exposure methods of the present invention is used in at least one of steps of forming a circuit pattern for making up an electronic device.

A second electronic device manufacturing method as still another aspect of the present invention is an electronic device manufacturing method wherein combined exposure of a projection exposure method using a projection exposure apparatus, and any one of the above-described exposure methods of the present invention is used in at least one of steps of forming a circuit pattern for making up an electronic device.

A first exposure apparatus as another aspect of the present invention is an exposure apparatus for effecting exposure on a photosensitive substrate, of an interference pattern generated by a first diffraction grating and a second diffraction grating with illumination light from a light source, the exposure apparatus comprising: a first holding mechanism for holding the first diffraction grating substantially in correspondence with a first plane while keeping a direction of a period of the first diffraction grating coincident with a first direction and a longitudinal direction of the first diffraction grating coincident with a second direction perpendicular to the first direction; a second holding mechanism for holding the second diffraction grating substantially in correspondence with a second plane located at a first effective distance and on the opposite side to the light source from the first plane while keeping a direction of a period of the second diffraction grating coincident with the first direction and a longitudinal direction of the second diffraction grating coincident with the second direction; a substrate holding mechanism for holding the substrate substantially in correspondence with a third plane located on the opposite side to the first plane and at a second effective distance substantially equal to the first effective distance from the second plane; and an illumination optical system for applying the illumination light from the light source onto the first plane, wherein a principal component of the illumination light applied onto a predetermined point in the first plane comprises a plurality of illumination light beams having respective traveling directions substantially in correspondence with a specific plane which includes the second direction and which is substantially normal to the first plane.

The first exposure apparatus can also be arranged as follows: an effective angle of a deviation from a direction in the specific plane, of the traveling directions of the principal component of the illumination light applied onto the first plane is within 1 [mrad], as an example.

A second exposure apparatus as still another aspect of the present invention is an exposure apparatus for effecting exposure on a photosensitive substrate, of an interference pattern generated by a first diffraction grating and a second diffraction grating with illumination light from a light source, the exposure apparatus comprising: a first holding mechanism for holding the first diffraction grating substantially in correspondence with a first plane while keeping a direction of a period of the first diffraction grating coincident with a first direction and a longitudinal direction of the first diffraction grating coincident with a second direction perpendicular to the first direction; a second holding mechanism for holding the second diffraction grating substantially in correspondence with a second plane located at a first effective distance and on the opposite side to the light source from the first plane while keeping a direction of a period of the second diffraction grating coincident with the first direction and a longitudinal direction of the second diffraction grating coincident with the second direction; a substrate holding mechanism for holding the substrate substantially in correspondence with a third plane located on the opposite side to the first plane and at a second effective distance substantially equal to the first effective distance from the second plane; and an illumination optical system for applying the illumination light from the light source onto the first plane, wherein a range of effective incidence angles of the illumination light applied onto a predetermined point in the first plane is not more than 2 [mrad] in the first direction, and is more than 2 [mrad] in the second direction.

Furthermore, the second exposure apparatus can also be arranged as follows: the range of effective incidence angles of the illumination light applied onto the predetermined point on the first plane is not more than 1 [mrad] in the first direction, and is more than 5 [mrad] in the second direction.

The first exposure apparatus and the second exposure apparatus as the aspects of the present invention described above are able to effect the exposure onto the photosensitive substrate in an optimized state of the relationship of the period directions and the longitudinal directions of the first diffraction grating and the second diffraction grating with the effective range of incidence angles of the illumination light. For this reason, high-contrast or high-resolution interference fringes can be formed with a good margin on the photosensitive substrate and the exposure thereof can be effected on the photosensitive substrate.

The illumination optical system can be one comprising illumination light uniformizing means for substantially uniformizing an intensity distribution of the illumination light in the first plane.
The illumination light uniformizing means can be one comprising at least one fly's eye lens in which lens elements are arrayed along the second direction, as an example.

A third exposure apparatus as another aspect of the present invention is an exposure apparatus for effecting exposure on a photosensitive substrate, of an interference pattern generated by a first diffraction grating and a second diffraction grating with illumination light from a light source, the exposure apparatus comprising: a first holding mechanism for holding the first diffraction grating substantially in correspondence with a first plane while keeping a direction of a period of the first diffraction grating coincident with a first direction and a longitudinal direction of the first diffraction grating coincident with a second direction perpendicular to the first direction; a second holding mechanism for holding the second diffraction grating substantially in correspondence with a second plane located at a first effective distance and on the opposite side to the light source from the first plane while keeping a direction of a period of the second diffraction grating coincident with the first direction and a longitudinal direction of the second diffraction grating coincident with the second direction; a substrate holding mechanism for holding the substrate substantially in correspondence with a third plane located on the opposite side to the first plane and at a second effective distance substantially equal to the first effective distance from the second plane; an illumination optical system for applying the illumination light from the light source onto the first plane; and a third holding mechanism for holding a diffracted light selecting member having transmittances for the diffracted light varying according to traveling directions of the diffracted light, substantially in correspondence with a fourth plane between the first plane and the third plane.

A fourth exposure apparatus as another aspect of the present invention is an exposure apparatus for effecting exposure on a photosensitive substrate, of an interference pattern generated by a first diffraction grating and a second diffraction grating with illumination light from a light source, the exposure apparatus comprising: a first holding mechanism for holding the first diffraction grating substantially in correspondence with a first plane while keeping a direction of a period of the first diffraction grating coincident with a first direction and a longitudinal direction of the first diffraction grating coincident with a second direction perpendicular to the first direction; a second holding mechanism for holding the second diffraction grating substantially in correspondence with a second plane located at a first effective distance and on the opposite side to the light source from the first plane while keeping a direction of a period of the second diffraction grating coincident with the first direction and a longitudinal direction of the second diffraction grating coincident with the second direction; a substrate holding mechanism for holding the substrate substantially in correspondence with a third plane located on the opposite side to the first plane and at a second effective distance substantially equal to the first effective distance from the second plane; an illumination optical system for applying the illumination light from the light source onto the first plane; and a diffracted light selecting member located between the first plane and the third plane and having transmittances for the diffracted light varying according to traveling directions of the diffracted light.

According to the third exposure apparatus and the fourth exposure apparatus as the aspects of the present invention described above, the diffracted light having predetermined traveling directions can be reduced relative to the other diffracted light, among the diffracted light generated from the first diffraction grating or from the second diffraction grating and the desired diffracted light can be relatively preferentially used to form the interference fringes on the photosensitive substrate. Therefore, much preferred interference fringes with higher contrast can be formed and the exposure thereof can be effected on the photosensitive substrate.

The fourth exposure apparatus as the aspect of the present invention can also be arranged as follows: the transmittances of the diffracted light selecting member are low for light incident at a small angle of incidence to the diffracted light selecting member and high for light incident at a large angle of incidence to the diffracted light selecting member.

In any one of the first exposure apparatus, the second exposure apparatus, the third exposure apparatus, and the fourth exposure apparatus as the aspects of the present invention, the first effective distance and the second effective distance both can be not less than 1 mm and not more than 15 mm, as an example.

Furthermore, a difference between the first effective distance and the second effective distance can be not more than 100 $\mu$m, as an example.

The exposure apparatus can also be arranged as follows: at least one of the first effective distance and the second effective distance, or a difference between the first effective distance and the second effective distance is determined according to a convergence/divergence state in the first direction of the illumination light applied onto the first plane, and expansion/contraction of the substrate, or further according to a predetermined condition.

In another arrangement, the exposure apparatus can also be arranged as follows: a convergence/divergence state in the first direction of the illumination light applied onto the first plane is determined according to the first effective distance and the second effective distance, expansion/contraction of the substrate, or a predetermined condition.

Incidentally, any one of the first exposure apparatus, the second exposure apparatus, the third exposure apparatus, and the fourth exposure apparatus as the aspects of the present invention can be arranged as follows: either the first holding mechanism and the second holding mechanism, or the substrate holding mechanism comprises a scanning mechanism for causing a relative movement in the second direction, for a relative positional relation of the first diffraction grating and the second diffraction grating to the substrate.

In another arrangement, either the first holding mechanism and the second holding mechanism, or the substrate holding mechanism comprises a moving mechanism for causing a relative movement in the first direction, for a relative positional relation of the first diffraction grating and the second diffraction grating to the substrate.

Any one of the first exposure apparatus, the second exposure apparatus, the third exposure apparatus, and the fourth exposure apparatus as the aspects of the present invention can be arranged as follows: the exposure apparatus comprises a liquid supply mechanism for filling at least a part of the second plane and the third plane, with a dielectric liquid having a refractive index of not less than 1.2 at a wavelength of the exposure.

An illumination optical apparatus as another aspect of the present invention is an illumination optical apparatus for applying illumination light from a light source onto a predetermined surface to be illuminated, wherein a range of effective incidence angles of the illumination light applied onto a predetermined point on the surface to be illuminated is not more than 2 [mrad] in a first direction in the surface to be illuminated, and is a value of more than 2 [mrad] in a second direction perpendicular to the first direction in the surface to be illuminated, the illumination optical apparatus comprising a field stop for restricting a shape of the illumination light applied onto the surface to be illuminated, to a predetermined shape.

Furthermore, the illumination optical apparatus can also be arranged as follows: the range of effective incidence angles of the illumination light applied onto the predetermined point on the first plane is not more than 1 [mrad] in the first direction, and is more than 5 [mrad] in the second direction.

The shape of the illumination light applied onto the surface to be illuminated can be one varying in a width in the second direction, depending upon positions in the first direction. Alternatively, the shape of the illumination light applied onto the surface to be illuminated can also be one varying in a width in the first direction, depending upon positions in the second direction.

The illumination optical apparatus as the aspect of the present invention can also be arranged to further comprise illumination light uniformizing means for substantially uniformizing an intensity distribution of the illumination light in the surface to be illuminated.

The illumination light uniformizing means can be one including at least one fly's eye lens in which lens elements are arrayed along the specific direction, as an example.

The illumination optical apparatus can also be arranged to further comprise a convergence/divergence adjusting mechanism for making variable a convergence/divergence state in the first direction of the illumination light applied into the surface to be illuminated.

**Brief Description of the Drawings**

Fig. 1 is a drawing schematically showing an exposure apparatus of the present invention.

Fig. 2 is a drawing to illustrate an example of a first diffraction grating G11 and a second diffraction grating G21, wherein (A) is a drawing showing the first diffraction grating G11 formed on a first optically-transparent flat plate P1 and (B) is a drawing showing the second diffraction grating G21 formed on a second optically-transparent flat plate P2.

Fig. 3 is a sectional view showing a positional relation among the first diffraction grating G11, the second diffraction grating G21, and a wafer W, and rays of diffracted light LP, LM, LP0, LP1.

Fig. 4 is a sectional view showing an intensity distribution of interference fringes formed on the wafer W.

Fig. 5 is a drawing showing a first effective distance L1 and a second effective distance L2.

Fig. 6 is a drawing to illustrate influence of deviation in an incidence angle of illumination light on positional deviation of the intensity distribution of interference fringes formed on the wafer W, wherein (A) and (B) are drawings showing a case without deviation in an incidence angle of illumination light and (C) and (B) are drawings showing a case with deviation in an incidence angle of illumination light..

Fig. 7 is a drawing showing an example of illumination light uniformizing means, wherein (A) is a drawing showing a shape in the XY plane of input fly's eye lens 11, (B) is a drawing showing a shape in the XY plane of fly's eye lens 13, (C) is a drawing showing a side view from the + X-direction, and (D) is a drawing showing a side view from the - Y-direction.

Fig. 8 is a drawing showing incidence angle ranges of illumination light to the first optically-transparent flat plate, wherein (A) is a drawing showing a side view from the first + X-direction, (B) is a drawing showing a side view from the - Y-direction, and (C) is a drawing showing an aperture stop 28.

Fig. 9 is a drawing showing an example of secondary illuminant position correcting means.

Fig. 10 is a drawing showing another example of the secondary illuminant position correcting means.

Fig. 11 is a drawing showing another example of the illumination light uniformizing means, wherein (A) is a drawing showing a side view from the + X-direction and (B) is a drawing showing a side view from the - Y-direction.

Fig. 12 is a drawing showing another embodiment of the exposure apparatus of the present invention.

Fig. 13 is a sectional view showing an example of field stop 22.

Fig. 14 is a drawing showing still another embodiment of the exposure apparatus of the present invention.

Fig. 15 is a drawing to illustrate a convergence/divergence state of illumination light to the first optically-transparent flat plate.

Fig. 16 is a drawing showing a diffracted light selecting member.

Fig. 17 is a drawing showing a relation of transmittance versus incidence angle of the diffracted light selecting member.

Fig. 18 is a drawing showing a state in which a first diffraction grating G13 and a second diffraction grating G14 are provided on two sides of an optically-transparent flat plate P3, respectively.

Fig. 19 is a drawing showing an example in which a second diffraction grating G16 is provided substantially inside a second optically-transparent flat plate P6.

Fig. 20 is a drawing showing a holding mechanism 36a for the first optically-transparent flat plate P1 and a holding mechanism 37a for the second optically-transparent flat plate P2.

Fig. 21 is a drawing showing a replacing mechanism 42 for the second optically-transparent flat plate P2, and others, wherein (A) is a bottom view thereof and (B) is a sectional view thereof at position A-B.

Fig. 22 is a drawing to illustrate a mechanism for filling a space between the wafer W and the second optically-transparent flat plate P2, and others with a liquid, wherein (A) is a drawing to illustrate a mechanism for filling only the space between the wafer W and the second optically-transparent flat plate P2 and (B) is a drawing to illustrate a mechanism for further filling a space between the optically-transparent flat plate P2 and the optically-transparent flat plate P1 with a liquid as well.

Description of Reference Symbols

1 light source; 2, 3, 4, 6 lenses in a first lens group; 10 condensing optical system; 13 fly's eye lens; 17 illumination aperture stop; 29, 30, 32, 35 lenses in a fourth lens group; P1 first optically-transparent flat plate; P2 second optically-transparent flat plate; 36a, 36b first holding mechanism; 37a, 37b second holding mechanism; W substrate (wafer); 38 wafer stage; 40 laser interferometer; G11, G13 first diffraction grating; G21, G14, G16 second diffraction grating; IL1-IL10 illumination light.

**Best Modes for Carrying out the Invention**

Embodiments of the present invention will be described below.

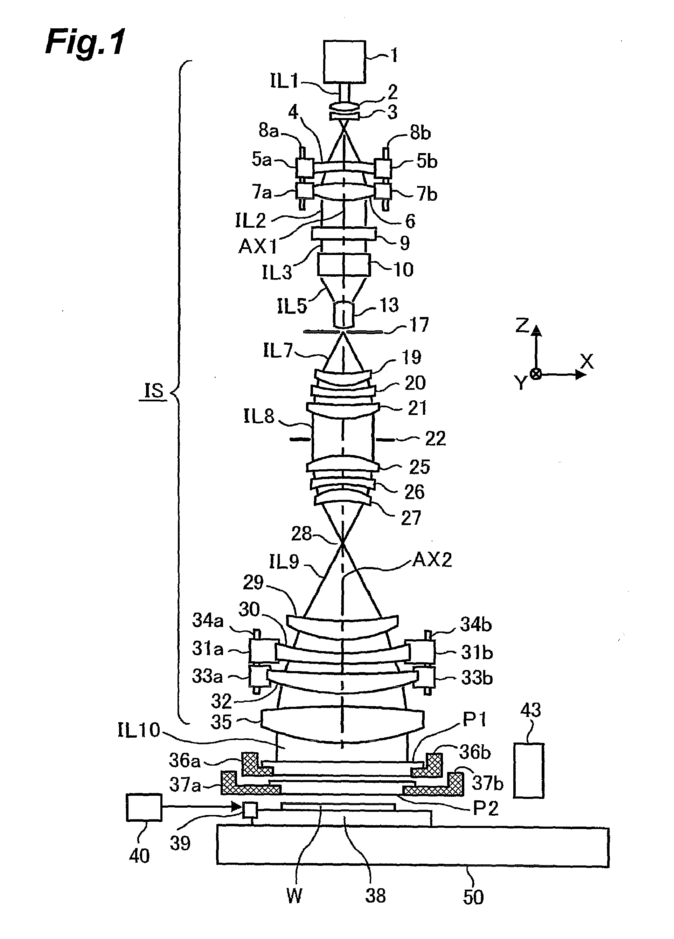

Fig. 1 is an overall view showing a first embodiment of the exposure apparatus according to the present invention. The XYZ coordinate system shown in Fig. 1 is the same as that shown in each of the drawings thereafter, and each of predetermined directions (X-direction, Y-direction, and Z-direction) indicates the same direction throughout the drawings.

Illumination light IL1 emitted from a light source 1, such as an ArF (argon-fluorine) excimer laser, a KrF (krypton-fluorine) excimer laser, an F2 (fluorine dimer) laser, or a harmonic laser using a wavelength conversion element, is converted into illumination light IL2 as a bundle of parallel rays (parallel beam) having a predetermined beam size, by lenses 2, 3, 4, 6 arranged along the first optical axis AX1 and forming a first lens group.

The illumination light IL2 is converted into illumination light IL3 whose polarization is set in a predetermined polarization state, by a polarization control element 9, and the illumination light IL3 is then incident to a condensing optical system 10 forming a part of an illumination light uniformizing means. Then illumination light IL5 emerging from the condensing optical system 10 enters an optical integrator such as a fly's eye lens 13 forming a part of the illumination light uniformizing means.

An aperture stop 17 is located, if necessary, on the exit-side surface of the fly's eye lens 13. The details of the illumination light uniformizing means consisting of the condensing optical system 10, fly's eye lens 13, aperture stop 17, etc. will be described later.

Illumination light IL7 emerging from the fly's eye lens 13 is then incident to lenses 19, 20, 21 arranged along the second optical axis AX2 and forming a second lens group, is refracted by these lenses, and is then incident as illumination light IL8 to a field stop 22. The field stop 22 will be described later.

The illumination light transmitted by the field stop 22 is further refracted by lenses 25, 26, 27 arranged along the second optical axis AX2 and forming a third lens group, and then travels to a focus point 28. The focus point 28 is conjugate (in an imaging relation) with the exit-side surface of the fly's eye lens 13 through the second lens group 19, 20, 21 and the third lens group 25, 26, 27.

Then illumination light IL9 passing the focus point 28 is further refracted by lenses 29, 30, 32, 35 forming a fourth lens group, and is incident as illumination light IL 10 to a first optically-transparent flat plate P1.

The optical members on the optical path of the illumination light IL1-IL10 from the above-described first lens group 2, 3, 4, 5 to the fourth lens group 29, 30, 32, 35 will be referred to hereinafter as an illumination optical system IS. This illumination optical system IS can also be regarded as an "illumination optical apparatus" a predetermined illumination plane of which is the plane where the first optically-transparent flat plate P1 is placed.

A second optically-transparent flat plate P2 is provided below the first optically-transparent flat plate P1 (in the - Z-direction). The second optically-transparent flat plate P2 is arranged opposite to a substrate W (hereinafter also referred to as a wafer on an as-needed basis) such as a semiconductor wafer which is a processed object in which a pattern is to be formed.

A first diffraction grating described below is formed in the first optically-transparent flat plate P1 and when the illumination light IL 10 is applied onto the first diffraction grating, diffracted light is generated thereby and is applied onto the second optically-transparent flat plate P2. A second diffraction grating described below is formed in the second optically-transparent flat plate P2 and the diffracted light is applied onto the second diffraction grating. Diffracted light generated by the second diffraction grating is applied onto the wafer W whereby a light-dark pattern of interference fringes composed of a plurality of diffracted light beams is formed on the wafer W.

A photosensitive member PR such as a photoresist for the light-dark pattern to be printed and recorded is formed on the surface of the wafer W. Namely, the wafer W can be regarded as a "photosensitive substrate."

The wafer W is held on a wafer stage 38 as a substrate holding mechanism movable in the XY directions on a wafer platen 50, whereby it is movable in the XY directions. The X-directional position of the wafer W is measured by a laser interferometer 40 through a position of a moving mirror 39 provided on the wafer stage 38, and the Y-directional position thereof is also measured by an unrepresented laser interferometer through a position of an unrepresented moving mirror provided on the wafer stage 38.

A wafer mark detecting mechanism 43 is a mechanism comprised of an optical microscope and adapted for detecting a position of an existing circuit pattern or an alignment mark on the wafer W, and the wafer W held on the wafer stage 38 is moved from above the wafer stage 38 to immediately below the wafer mark detecting mechanism 43 according to need before exposure, followed by detection of the position of the pattern or mark on the wafer W.

The second optically-transparent flat plate P2 is held by a second holding mechanism 37a, 37b so as to be arranged opposite to the wafer W with a predetermined spacing described below. The first optically-transparent flat plate P1 is held by a first holding mechanism 36a, 36b so as to be arranged opposite to the second optically-transparent flat plate P2 with a predetermined spacing described below.

The wafer W has, for example, the diameter of 300 mm, and the second optically-transparent flat plate P2 has the diameter enough to cover the entire surface of the front face of the wafer W as an example. Likewise, the first optically-transparent flat plate P1 also has the diameter enough to cover the entire surface of the front face of the second optically-transparent flat plate P2 as an example. It is, however, preferable, as described below, that the diameter of the second optically-transparent flat plate P2 be at least about 30 mm larger than the diameter of the wafer W.

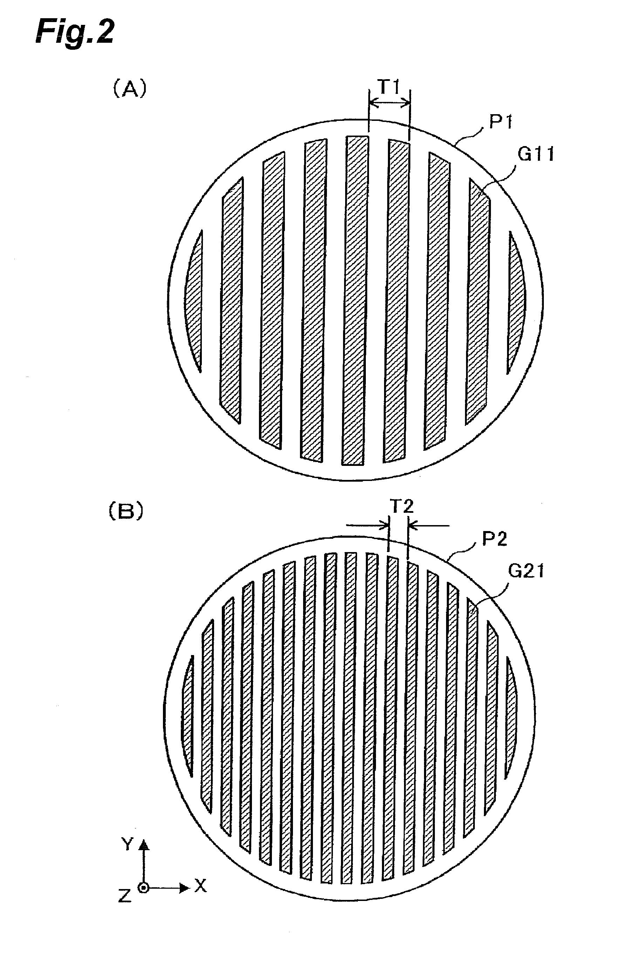

The light-dark pattern of interference fringes formed on the wafer W according to the present invention will be described below with reference to Figs. 2, 3, and 4.

A one-dimensional phase modulation type diffraction grating G11 with periodicity in the X-direction is formed on the surface on the + Z-side, i.e., on the light source 1 side of the first optically-transparent flat plate P1. The X-direction can be regarded as the "first direction." Furthermore, a one-dimensional phase modulation type diffraction grating G21 with periodicity in the X-direction is also formed on the surface on the + Z-side, i.e., on the first optically-transparent flat plate P 1 side of the second optically-transparent flat plate P2.

First, these diffraction gratings G11, G21 will be described referring to Fig. 2.

Fig. 2 (A) is a view of the first optically-transparent flat plate P1 from the + Z-side, and the phase modulation type first diffraction grating G11, which has the longitudinal direction along the Y-direction and the one-dimensional period T1 in the X-direction perpendicular to it, is formed on the surface of the plate P1. The Y-direction herein can be regarded as the "second direction."

The first diffraction grating G11 is composed of surface portions of the first optically-transparent flat plate P1, and indentations (hatched portions in Fig. 2 (A)) formed by engraving the surface of the flat plate by etching or the like, like a so-called chromeless phase shift reticle. The depth of the indentations is so set that the phase difference of 180° is made between illumination light transmitted by the surface portions and illumination light transmitted by the indentations. When the phase difference of 180° is made between the two illumination beams, the depth of the indentations is defined as indicated by the following Formula 1:

$$(2m - 1)\lambda/(2(n - 1)),$$

where $\lambda$ is the wavelength of exposure light, n the refractive index of the first optically-transparent flat plate P1, and m an arbitrary natural number.

A ratio of widths of the surface portions and indentations (duty ratio) is preferably set to approximately 1:1. It is, however, noted that the above-described phase difference and duty ratio can be other values different from 180° and 1: 1 described above.

Fig. 2 (B) is a view of the second optically-transparent flat plate P2 from the + Z-side, and the second diffraction grating G21, which has the longitudinal direction along the Y-direction and the one-dimensional period T2 in the X-direction, is formed on the front surface of the plate P2 (the surface on the first optically-transparent flat plate P1 side). The second diffraction grating G21 also has a structure similar to that of the above-described first diffraction grating G11.

The first optically-transparent flat plate P1 and the second optically-transparent flat plate P2 are made of a material that is highly transparent to ultraviolet light, that has a small coefficient of thermal expansion (linear expansion coefficient), and that thus undergoes less thermal deformation with absorption of the exposure light, such as synthetic silica. The thicknesses of the flat plates are preferably, for example, not less than 5 mm, in order to prevent deformation such as self-weight deformation. However, in order to further prevent the self-weight deformation and the like, the thicknesses can be not less than 10 mm. Particularly, where the F2 laser is used as the light source 1, a preferred material is synthetic silica doped with fluorine.

In Fig. 2 (A) and (B), for convenience' sake of description, the period T1 is illustrated as if to be approximately 10% of the diameter of the first optically-transparent flat plate P1 (300 mm or more as an example), but in fact the period T1 is, for example, approximately 240 nm and the period T2, for example, approximately 120 nm, which are overwhelmingly smaller than the diameter of the first optically-transparent flat plate P1. This is also the case in each of the drawings other than Fig. 2 (A) and (B).

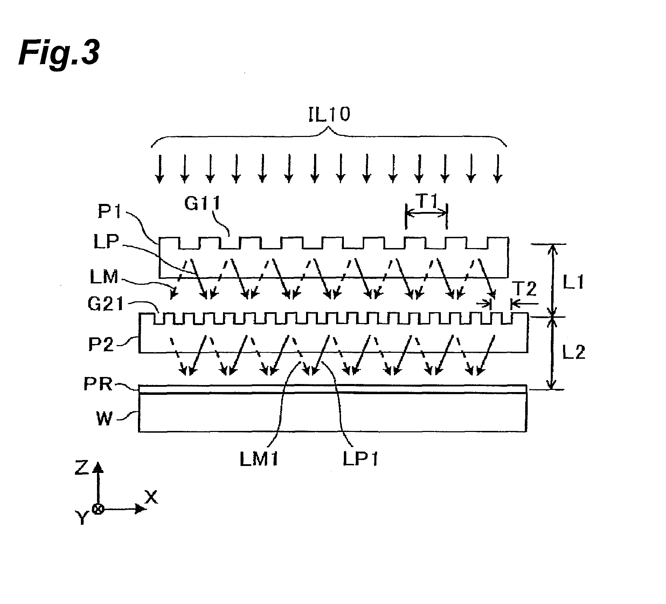

The following will describe, referring to Fig. 3, how the light-dark pattern of interference fringes is formed on the wafer W with application of the illumination light IL 10 onto the first diffraction grating G11 and the second diffraction grating G21.

Fig. 3 is a drawing showing cross sections of the first optically-transparent flat plate P1, the second optically-transparent flat plate P2, and the wafer W arranged opposite to each other.

When the illumination light IL10 is applied, the first diffraction grating G11 generates diffracted light according to the period T1. When the first diffraction grating G11 is a phase modulation type grating with the duty ratio of 1:1 and the phase difference of 180°, the diffracted light thus generated is composed mainly of + first-order diffracted light LP and - first-order diffracted light LM. However, the diffracted light of the other orders can also be generated.

An angle θ of diffraction of the ± first-order diffracted light is an angle represented by Formula 2 below:

$$\sin\theta = \lambda / T1,$$

where $\lambda$ is the wavelength of the exposure light.

This is, however, an angle of diffraction after the ± first-order diffracted light LP, LM has passed through the first optically-transparent flat plate P1 and emerged into air (which also contains "nitrogen and rare gas" ; the same also applies to the description hereinafter). Namely, an angle of diffraction of the $\pm$ first-order diffracted light LP, LM in the first optically-transparent flat plate P1, θ', is an angle represented by Formula 3 below:

$$\sin\theta' = \lambda / (n \times T1),$$

using the refractive index n of the first optically-transparent flat plate P1.

Subsequently, the $\pm$ first-order diffracted light LP, LM is incident to the second diffraction grating G21 on the second optically-transparent flat plate P2. Since the second diffraction grating G21 is also a phase modulation type diffraction grating as described above, the second diffraction grating G21 also mainly generates $\pm$ first-order diffracted light.

In the present example, the period T2 of the second diffraction grating G21 is half the period T1 of the first diffraction grating G11, i.e., the condition of T1 = 2 × T2 is met. In this case, the - first-order diffracted light LP1 generated upon application of the + first-order diffracted light LP onto the second diffraction grating G21 is generated at the angle θ of inclination relative to the Z-direction toward the - X-direction. Furthermore, the + first-order diffracted light LM1 generated upon application of the - first-order diffracted light LM onto the second diffraction grating G21 is generated at the angle θ of inclination relative to the Z-direction toward the + X-direction. It is also possible to use a second diffraction grating satisfying T2 = T1, on the assumption that the second-order diffracted light generated by the second diffraction grating G21 is used.

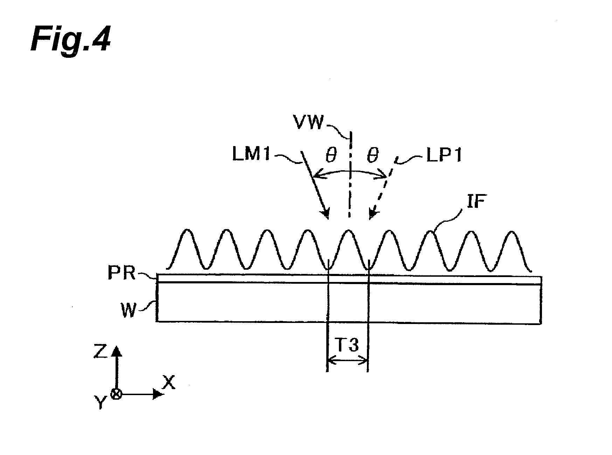

As shown in Fig. 4, the two diffracted light beams are applied at the foregoing inclination angle relative to the vertical direction (direction of a normal) ZW to the wafer W, onto the wafer W to form a light-dark pattern IF of interference fringes on the wafer W. At this time, the period T3 of the light-dark pattern of interference fringes (period of the intensity distribution) formed on the wafer W is given by Formula 4 below:

$$T3 = \lambda / (2 \times \sin\theta).$$

This is half the period T1 of the first diffraction grating G11 and is equal to the period T2 of the second diffraction grating G21.

The photosensitive member PR such as a photoresist formed on the surface of the wafer W, is exposed to this light-dark pattern IF in accordance with light and dark portions of the pattern, whereby the light-dark pattern IF is transferred onto the wafer W.

Therefore, the light-dark pattern parallel to the Y-direction with the period T3 in the X-direction is formed over the entire surface of the wafer W. Then the photoresist PR formed on the wafer W is illuminated with and exposed to this light-dark pattern.

Incidentally, where the period T2 of the second diffraction grating G21 is larger than the predetermined value, the + first-order diffracted light, not shown, is generated upon application of the + first-order diffracted light LP onto the second diffraction grating G21 and the - first-order diffracted light, not shown, is generated upon application of the - first-order diffracted light LM onto the second diffraction grating G21. Such diffracted light serves as unwanted diffracted light to lower the contrast of the light-dark pattern IF.

However, when the period T1 and the period T2 are approximately equal to or smaller than the wavelength λ of the illumination light, sine's (sin's) of angles of emergence of the + first-order diffracted light of the + first-order diffracted light LP and the - first-order diffracted light of the - first-order diffracted light LP from the second diffraction grating G21 exceed 1 formally from Formula 2; i.e., such diffracted light cannot be generated.

The upper limit of the period T2 is given by Formula 5 below:

$$T2 = 3\lambda / 2.$$

From T1 = 2 × T2, the upper limit of the period T1 is 3λ.

Therefore, application of the above-described unwanted diffracted light onto the wafer W can be prevented as long as the period of the first diffraction grating G11 is not more than 3λ.

It is, however, noted that this is the condition in the case where at least a part of the optical path space from the first diffraction grating G11 to the wafer W is wholly filled with air, and that the condition must differ in a case where the entire optical path space is covered by a medium such as a dielectric with the refractive index effectively larger than 1. The reason is that the increase in the refractive index of the medium decreases the diffraction angles, as seen from Formula 3.

In this case, where an effective wavelength λe (= λ / ne) is defined as a wavelength of the illumination light in a medium with a minimum refractive index ne among the media present on the illumination optical path from the first diffraction grating G11 to the wafer W, the upper limit of the period T2 is 3λe/2 and the upper limit of the period T1 is 3λe.

On the other hand, the period T1 of the first diffraction grating G11 has to be not less than λe, for generating the ± first-order diffracted light LP, LM. The reason is as follow: unless this condition is met, sine's of diffraction angles of the ± first-order diffracted light LP, LM in the medium with the foregoing minimum refractive index ne become over 1 whereupon the ± first-order diffracted light LP, LM fails to impinge upon the wafer W. From T1 = 2 × T2, the period T2 of the second diffraction grating G21 has to be larger than λe / 2.

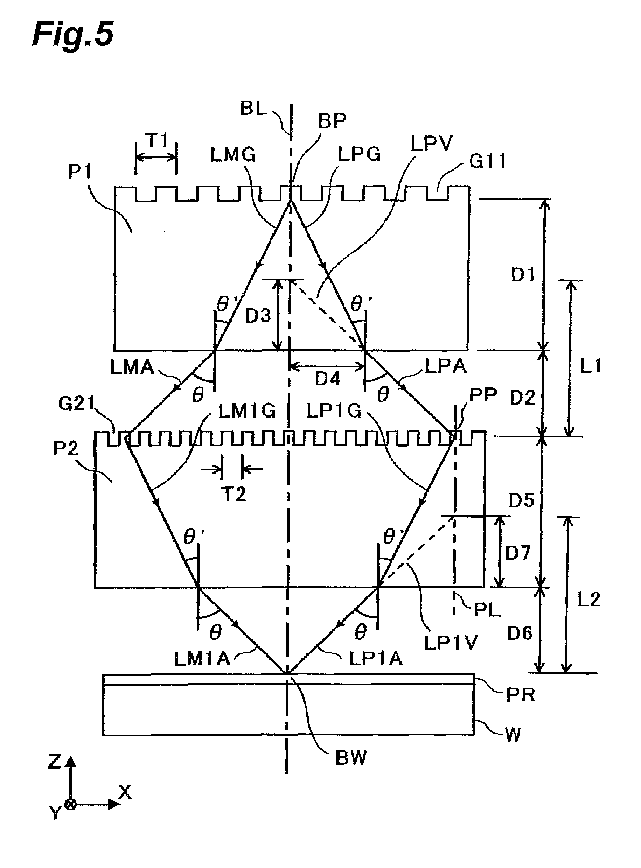

The following will describe the effective distance L1 between the first diffraction grating G11 and the second diffraction grating G21 and the effective distance L2 between the second diffraction grating G21 and the wafer W in the present invention, using Fig. 5.

As described above, the traveling directions or diffraction angles of the ± first-order diffracted light LP, LM vary depending upon the refractive indices of the media through which the ± first-order diffracted light LP, LM passes. An optically effective distance between the first diffraction grating G11 and the second diffraction grating G21 and an optically effective distance between the second diffraction grating G21 and the wafer W also vary depending upon the refractive index of the medium located between these two elements.

Therefore, when these are defined by actual physical distances, the meaning will be unclear; in the present invention, the spacing between the first diffraction grating G11 and the second diffraction grating G21 and the spacing between the second diffraction grating G21 and the wafer W are represented by "effective distances" defined below, in order to avoid the variation due to the refractive index of the medium.

The effective distances will be described below using Fig. 5.

Fig. 5 is a sectional view showing the first optically-transparent flat plate P1 on which the first diffraction grating G11 is formed and the second optically-transparent flat plate P2 on which the second diffraction grating G21 is formed. Fig. 5 also shows a + first-order diffracted light beam LPA, LPG and a - first-order diffracted light beam LMA, LMG equivalent to the foregoing ± first-order diffracted light LP, LM.

Since the thickness of the first optically-transparent flat plate P1 is D1 and the spacing between the first optically-transparent flat plate P1 and the second optically-transparent flat plate P2 is D2, the physical distance between the first diffraction grating G11 and the second diffraction grating G21 is D1 + D2.

However, the first "effective distance" L1 between the first diffraction grating G11 and the second diffraction grating G21 is defined as a sum of an in-air equivalent distance D3 of the thickness D1 of the first optically-transparent flat plate P1 and the spacing D1 between the first optically-transparent flat plate P1 and the second optically-transparent flat plate P2 filled with air.

First, the in-air equivalent distance refers to a distance defined as described below.

The + first-order diffracted light LPG generated from a first reference point BP, which is a predetermined arbitrary point on the first diffraction grating G11, travels as inclined at the diffraction angle 0' determined from Formula 3, relative to a first reference line BL as a normal to the first diffraction grating G11 through the first reference point BP, in the first optically-transparent flat plate P1 with the refractive index n. However, the + first-order diffracted light LPA emerging from the first diffraction grating G11 into air with the refractive index of 1 travels as inclined at the diffraction angle θ determined from Formula 2, relative to the first reference line BL.

When it is assumed that the refractive index of the optically-transparent flat plate P1 is 1 and a virtual optical path LPV is assumed as an optical path resulting from reverse extension of the optical path of the + first-order diffracted light LPA, the virtual optical path LPV will intersect with the first reference line BL at a distance D3 above from the bottom surface of the optically-transparent flat plate P1.

Therefore, the optically-transparent flat plate P1 with the thickness D1 and the refractive index n can be considered to be equivalent to a medium having the thickness (distance) D3 as a reduced value in air, for the diffracted light traveling in the direction of the diffraction angle θ in air. D3 is then defined as the in-air equivalent distance of the optically-transparent flat plate P1.

Let us now consider the relationship between D1 and D3. Let D4 be a distance between a point of emergence of the + first-order diffracted light LPG from the optically-transparent flat plate P1 and the first reference line BL. Then Formula 6 and Formula 7 below hold.

$$\text{Formula 6: } D4 = D1 \times \tan \theta'$$

$$\text{Formula 7: } D4 = D3 \times \tan \theta$$

From these, we can derive Formula 8 below.

$$\text{Formula 8: } D3 = D1 \times \tan\theta' / \tan\theta$$

In view of Formula 2 and Formula 3, we obtain Formula 9 below.

$$\text{Formula 9: } D3 = D1 \times \cos\theta / (n \times \cos\theta')$$

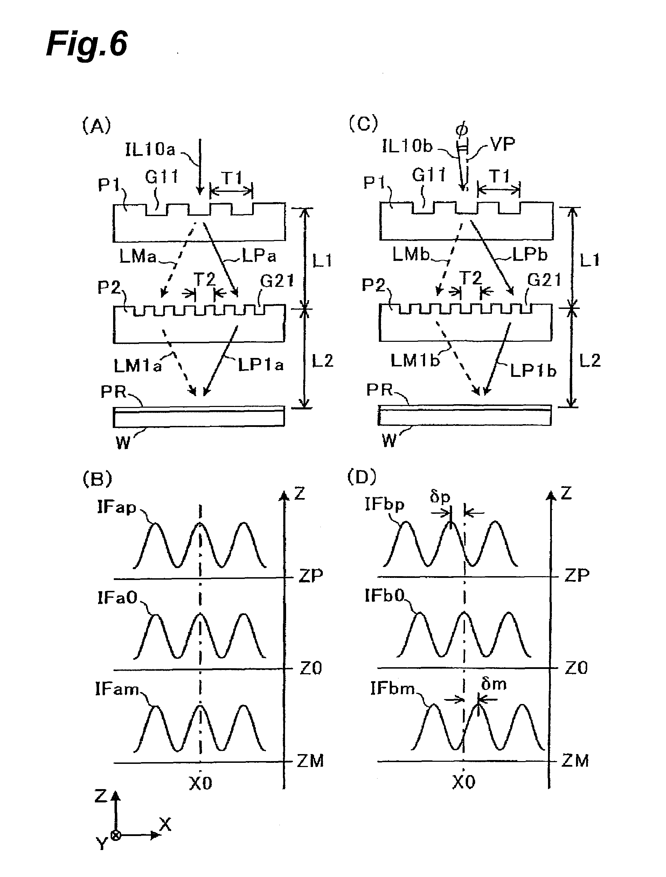

Since the spacing D1 between the first optically-transparent flat plate P1 and the second optically-transparent flat plate P2 is the space filled with air (n = 1), the in-air equivalent distance thereof is nothing but D1.
Therefore, the first effective distance L1 between the first diffraction grating G11 and the second diffraction grating G21 is the sum of D3 and D1 discussed above.
The second effective distance L2 between the second diffraction grating G21 and the wafer W can also be defined as an effective distance L2 in the same manner as above.
In this case, an in-air equivalent distance D7 of the second optically-transparent flat plate P2 can be defined as follows.
Let us define a second reference point PP at a point where the + first-order diffracted light LPA emerging at the first reference point BP from the first diffraction grating G11 is incident to the second diffraction grating G21, and a second reference line PL as a normal to the second diffraction grating G21 through the second reference point PP. In addition, let LP 1V be an optical path resulting from reverse extension of the - first-order diffracted light LP1A in air on the assumption that the refractive index of the second diffraction grating G21 is 1. Then the in-air equivalent distance D7 is defined as a distance between a point of intersection of the optical path LP1V with the above-defined second reference line PL, and the bottom surface of the second optically-transparent flat plate P2.
Since the space between the second optically-transparent flat plate P2 and the wafer W (more precisely, the photoresist PR) is filled with air (n = 1), an in-air equivalent distance thereof is exactly D6.
Therefore, the second effective distance L2 between the second optically-transparent flat plate P2 and the wafer W is obtained as the sum of D7 and D6 defined above.
The above described how to calculate the effective distances in the case of the single optically-transparent flat plate P1, P2 and the aerial spacing D2, D6, and the effective distances can also be calculated in the same manner in cases where there are a plurality of media having the refractive index larger than 1. Specifically, the aforementioned in-air equivalent distance is obtained for each of the media and the effective distance is defined as the sum of the in-air equivalent distances thus obtained.
In the present invention, the first effective distance L1 and the second effective distance L2 are so set that the first effective distance L1 between the first diffraction grating G11 and the second diffraction grating G21 is approximately equal to the second effective distance L2 between the second diffraction grating G21 and the wafer W.
This permits the $\pm$ first-order diffracted light beams LP (LPG), LM (LMG) leaving an arbitrary point BP on the first diffraction grating G11 to be guided to BW as a point on the first reference line BL on the wafer W, as shown in Fig. 5. Namely, diffracted light beams applied onto a point (e.g., BW) on the wafer W are the $\pm$ first-order diffracted light beams LP, LM emerging from the same point (e.g., BP) on the first diffraction grating G11, and thus those diffracted light beams always interfere with each other to form interference fringes with good contrast.
It is, however, noted that the first effective distance L 1 and the second effective distance L2 do not always have to accurately coincide with each other and that it is sufficient that they coincide within a certain level of coincidence.
The required level of coincidence between the first effective distance L1 and the second effective distance L2 is determined in relation to an incidence angle range of the illumination light IL10 applied onto the first optically-transparent flat plate P1.
This will be discussed below with Fig. 6.
Fig. 6 (A) is a drawing showing cross sections of the first optically-transparent flat plate P1, the second optically-transparent flat plate P2, and the wafer W, similar to Figs. 3 and 5. Fig. 6 (B) is a drawing showing light-dark pattern profiles of interference fringes formed on the wafer W, similar to Fig. 4, and shows three light-dark pattern profiles: a light-dark pattern profile IFaO in a case where the Z-position of the wafer W is so set that the second effective distance L2 is equal to the first effective distance L1 (Z = Z0); a light-dark pattern profile IFap in a case where the second effective distance L2 is $\Delta$Z shorter than the first effective distance L 1 (Z = ZP); a light-dark pattern profile IFam in a case where the second effective distance L2 is $\Delta$Z longer than the first effective distance L1.
In the case where the illumination light EL10a applied to the first diffraction grating G11 on the first optically-transparent flat plate P1 is perfectly parallel illumination light and where the angle of incidence thereof is 0, i.e., in the normal incidence case, the positions in the X-direction in the drawing of the light-dark pattern profiles IFap, IFa0, IFam formed on the wafer W are invariant regardless of the Z-directional positions of the wafer W, i.e., regardless of the difference between the first effective distance L1 and the second effective distance L2. Therefore, peak positions of intensity distributions of the light-dark pattern profiles IFap, IFa0, IFam are constant, X = X0.

On the other hand, Fig. 6 (C) is a drawing showing a case where the perfectly parallel illumination light IL10b applied to the first diffraction grating G11 on the first optically-transparent flat plate P1 is incident at an angle φ of inclination from the direction of a normal to the diffraction grating G11 toward the X-direction.

In this case, each first-order diffracted light LPb, LMb, LP1b, LM1b also travels in a direction inclined relative to each corresponding first-order diffracted light LPa, LMa, LP1a, LM1a in Fig. 6 (A) in correspondence to the inclination of the illumination light IL10b.

Then the X-directional positions of the light-dark pattern profiles of interference fringes formed on the wafer W also vary corresponding to the Z-directional positions of the wafer W in correspondence to the foregoing inclination of the applied first-order diffracted light LP1b, LM1b, as shown in Fig. 6 (D).

At this time, in the case where the Z-position of the wafer W is so set that the second effective distance L2 is equal to the first effective distance L1 (Z = Z0), the peak positions of intensity distribution in the light-dark pattern profile IFb0 are the same, X = X0, as in the case of normal incidence of the illumination light IL10 to the first diffraction grating G11.

However, in the case where the second effective distance L2 is set ΔZ shorter than the first effective distance L1 (Z = ZP), the peak positions of intensity distribution in the light-dark pattern profile IFbp are positions shifted by δp in the - X-direction from X = X0.

Furthermore, in the case where the second effective distance L2 is set ΔZ longer than the first effective distance L1 (Z = ZM), the peak positions of intensity distribution in the light-dark pattern profile IFbm are positions shifted by δm in the + X-direction from X = X0.

At this time, the relation of Formula 10 below holds.

$$\text{Formula 10: } \delta p = \delta m = \Delta Z \times \tan \varphi$$

In passing, when the illumination light incident to the first diffraction grating G11 is only the aforementioned IL10b inclined toward the X-direction, no reduction is made in the contrast though the positions of interference fringes formed on the wafer W deviate in the X-direction.

However, when the illumination light incident to the first diffraction grating G11, G12 is illumination light beams having a plurality of traveling directions with different inclination angles (incidence angles) to the X-direction, the positions of interference fringes formed by those illumination light beams are also different according to Formula 9 and this results in reducing the contrast of interference fringes finally formed by intensity superposition thereof. Therefore, under this condition, there are certain cases where it is difficult to implement exposure of a good pattern on the wafer W with a sufficient margin in the Z-direction.

Then the difference between the first effective distance L1 and the second effective distance L2 (referred to hereinafter as "Z-positional difference") is set to not more than a predetermined value, i.e., the wafer W is set within a predetermined range in the Z-direction, and the X-directional incidence angle range of the illumination light IL10 applied onto the first diffraction grating G11 is set to not more than a predetermined value, whereby it becomes feasible to effect exposure of a good pattern on the wafer W set within the predetermined Z-directional range.

The aforementioned Z-positional difference is, for example, not more than 30 [μm]. The aforementioned X-directional incidence angle range is, for example, not more than 2 [mrad].

At this time, the illumination light incident at the maximum angle of inclination to the + X-direction or at the inclination angle of + 1 [mrad] to the first diffraction grating G11 among the illumination light IL10 forms interference fringes on the wafer W set at the position + 30 [μm] apart from Z = Z0, while the peak positions δp of intensity distribution in the light-dark pattern IFbp of the interference fringes are 30 [nm] from Formula 9.

On the other hand, the illumination light incident at the maximum angle of inclination to the - X-direction or at the inclination angle of - 1 [mrad] to the first diffraction grating G11 among the illumination light IL10 forms interference fringes on the wafer W set at the aforementioned Z-position, while the peak positions δp of intensity distribution in the light-dark pattern IFbp of the interference fringes are - 30 [nm] from Formula 9.

Since the illumination light IL10 also contains the illumination light incident nearly normally to the X-direction to the first diffraction grating G11, when the aforementioned conditions of the incidence angle range and the Z-positional difference are satisfied, the sum (intensity addition) of the light-dark patterns IF of the interference fringes formed by these illumination light beams can be transferred to the photoresist PR on the wafer W with good contrast as long as the light-dark patterns have the period T3 of not less than about 150 [nm].

When it is necessary to implement exposure of a light-dark pattern IF with a smaller period T3, the foregoing conditions of the incidence angle range and Z-positional difference have to be set severer. Since a reduction in the contrast of the formed light-dark pattern IF is determined by the product of the incidence angle range and the Z-positional difference from Formula 10, the product is preferably set to not more than a predetermined value.

This product was 2[mrad] $\times$ 30[$\mu$m] = 60[mrad·$\mu$m] under the above conditions, but when the product is set, for example, to about half of it, a light-dark pattern with the period T3 of not less than about 75 [nm] can be transferred with good contrast to the photoresist PR on the wafer W.

This can be achieved, for example, by setting the X-directional incidence angle range to not more than 1 [mrad] and the Z-positional difference to not more than 30 [$\mu$m].

Alternatively, the Z-positional difference can be relaxed up to about 100 [$\mu$m] when the X-directional incidence angle range is set to a smaller value.

Incidentally, Y-directional inclination of the incidence angle of the illumination light IL10 changes the Y-directional positions of the interference fringes IF on the wafer W, but the light-dark pattern IF of interference fringes is approximately uniform interference fringes in the Y-direction in accordance with the shapes in the XY plane of the first diffraction grating G11 and the second diffraction grating G21; therefore, the Y-directional position change causes no problem at all.

Namely, the Y-directional inclination of the incidence angle of the illumination light IL10 causes no substantial positional deviation of the interference fringes and no reduction in the contrast of the interference fringes IF even when the illumination light IL10 is illumination light beams having a plurality of traveling directions with different inclination angles to the Y-direction.

Therefore, the illumination light IL10 applied to an arbitrary point on the first diffraction grating G11 needs to have the X-directional incidence angle within the predetermined range as described above, but may have a wide incidence angle range in the Y-direction.

In other words, it follows that the illumination light IL10 applied to an arbitrary point on the first diffraction grating G11 can be a plurality of illumination light beams having respective traveling directions within a plane including the Y-direction and the point of interest (referred to hereinafter as a "specific plane").

The incidence angle range in the X-direction, or an angular range of traveling directions can also deviate from the foregoing specific plane within about $\pm$ 1 [mrad] as described above, i.e., within the angular range of about 2 [mrad].

There are no particular restrictions on the upper limit of the Y-directional incidence angle range of the illumination light IL10, but it is desirable to set the Y-directional incidence angle range as wide as possible, in order to improve the uniformity of illuminance of the illumination light IL10 on the first diffraction grating G11.

As an example, it is thus desirable that the Y-directional incidence angle range of the illumination light IL 10 be larger than 2 [mrad]. When the X-directional incidence angle range of the illumination light IL10 is limited to not more than about 1 [mrad] as described above, the Y-directional incidence angle range is preferably set larger than 5 [mrad], in order to secure the uniformity of illuminance of the illumination light IL 10 on the first diffraction grating G11.

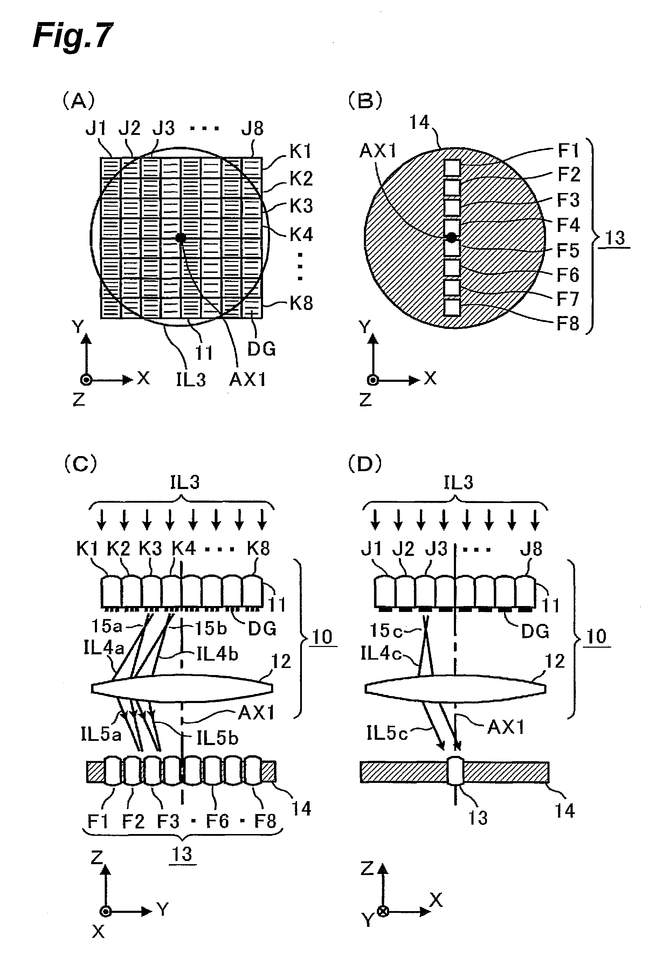

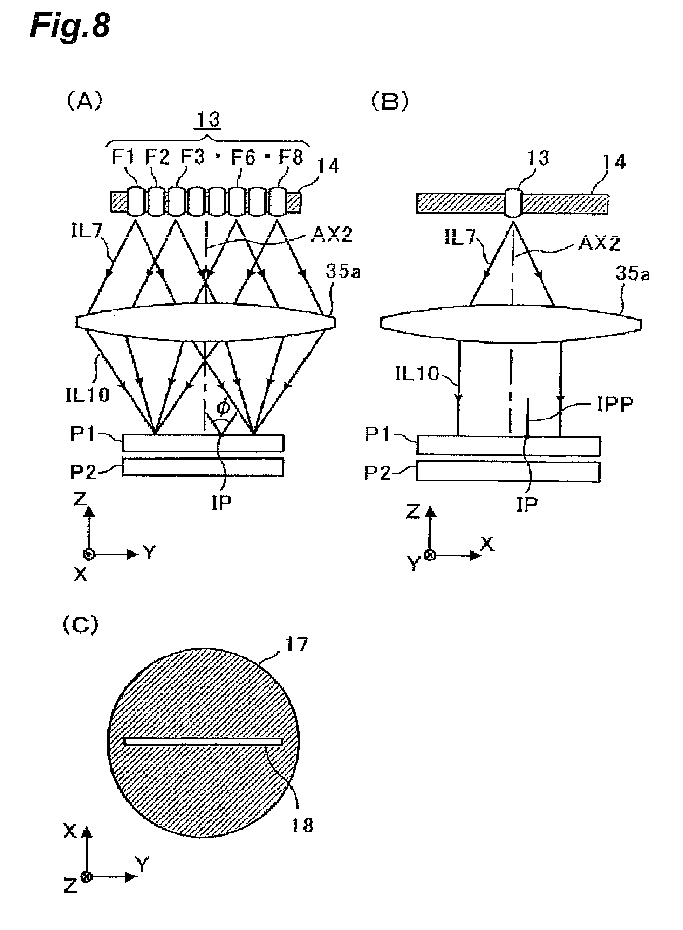

An example of the illumination light uniformizing means for implementing the illumination light IL10 satisfying the above conditions will be described below with reference to Figs. 7 and 8.

Fig. 7 (C) is a side view of the illumination light uniformizing means from the + X-direction, and Fig. 7 (D) a side view of the illumination light uniformizing means from the - Y-direction.

The illumination light uniformizing means of this example consists of a condensing optical system 10 consisting of an input fly's eye lens 11 and a condenser lens 12, and a fly's eye lens 13 in which lens elements F1, F2, F3, F4, F5, F6, F7, and F8 are arrayed on a line along the Y-direction on a light-shielding member 14.

Fig. 7 (A) is a view of the input fly's eye lens 11 from the + Z-direction, and Fig. 7 (B) a view of the fly's eye lens 13 from the + Z-direction.

The input fly's eye lens 11 is, for example, one consisting of sixty four lens elements, while having eight lines of lens elements J1, J2, J3, J4, J5, J6, J7, J8 (among which reference symbols J4 to J7 are omitted from illustration) in the X-direction and eight lines of lens elements K1, K2, K3, K4, K5, K6, K7, K8 (among which reference symbols K5 to K7 are omitted from illustration) in the Y-direction as well.

Fig. 8 (A) is a view from the + X-direction of the fly's eye lens 13, the illumination-system rear-group lens 35a, the first optically-transparent flat plate P1, and the second optically-transparent flat plate P2, and Fig. 8 (B) is a view from the - Y-direction thereof. The lenses in the illumination system are represented by the single general lens 35a for simplicity, but it actually represents a total of the second lens group 19, 20, 21, the third lens group 25, 26, 27, and the fourth group 29, 30, 32, 35 in the illumination optical system in Fig. 1.

When the illumination light IL2 is applied onto the input fly's eye lens 11, the illumination light impinges upon each lens element of the array on the fly's eye lens 13 as described below. Then the illumination light IL7 emerging from the fly's eye lens 13 is incident to the lens 35a, as shown in Fig. 8 (A) and (B). Then it is refracted by the general lens 35a to be incident as illumination light IL10 to the first optically-transparent flat plate P1.

However, since the fly's eye lens 13 is composed of the plurality of lens elements F1-F8 arranged on a line along the Y-direction, incidence angle characteristics of the illumination light IL10 to the first optically-transparent flat plate P1 are different between in the X-direction and in the Y-direction.

The general lens 35a is located so that its entrance focal plane coincides with the exit surface of the fly's eye lens 13 and that its exit focal plane coincides with the top surface (+ Z) of the first optically-transparent flat plate P1. Therefore, the general lens 35a constitutes a so-called Fourier transform lens.

Beams of illumination light IL7 emerging from the respective lens elements of the fly's eye lens 13 are refracted by the general lens 35a and are applied as illumination light IL10 in a superposed manner onto the first optically-transparent flat plate P1. Therefore, an intensity distribution of illumination light on the first optically-transparent flat plate P1 is uniformized by an averaging effect of the superposition.

The incidence angle range φ in the Y-direction of the illumination light IL10 to an arbitrary point IP on the first optically-transparent flat plate P1 is a predetermined value as shown in Fig. 7 (A) according to the array in the Y-direction of the fly's eye lens 13.

On the other hand, since the fly's eye lens 13 includes only one line in the X-direction, the incidence angle range in the X-direction can be set to not more than a predetermined value.

Therefore, the illumination light IL10 to one point IP can be a plurality of illumination light beams having respective traveling directions in a plane including the Y-direction and including the point IP (i.e., in the aforementioned specific plane), plane IPP, and the traveling directions are not parallel to each other.

In another potential example, an aperture stop 17 with an aperture 18 of a slit shape long in the Y-direction and narrow in the X-direction as shown in Fig. 8 (C) is provided on the exit surface of the fly's eye lens 13, if necessary, and it further limits the traveling directions in the X-direction of the illumination light IL 10 to within a plane parallel to the specific plane IPP. It is also possible to locate this aperture stop 17 at the position of the focus point 28 in Fig. 1 which is conjugate with the exit surface of the fly's eye lens 13.

A configuration of the input fly's eye lens 11 will be described below in detail.

Illumination light IL3 impinging upon each lens element forming the input fly's eye lens 11 is focused by the lens action of each lens element. Preferably, a blazed or multistep type diffraction grating DG, which folds the illumination light in the Y-direction, is formed on an exit surface of each lens element. The diffraction gratings DG formed on the lens elements arrayed at the same X-directional array position in the input fly's eye lens 11 are supposed all to have the same diffraction angle characteristic.

Therefore, the illumination light emerging from each lens element at the Y-directional array positions K1-K8 is subjected to the focusing action of each lens element and the diffraction (folding) action in the Y-direction by the diffraction grating DG

Fig. 7 (C) and Fig. 7 (D) show illumination light beams IL4a, IL4b emerging from the Y-directional array positions K3 and K4 at the X-directional array position J3 (which will be totally referred to as IL4c) as an example. As illustrated, the illumination light beams IL4a, IL4b, IL4c emerge from the lens elements and are then once focused at focal points 15a, 15b, 15c. Then the light beams are incident to the condenser lens 12 so arranged that the entrance focal plane thereof coincides with the focal points 15a, 15b, 15c and that the exit focal plane coincides with the entrance surface of the fly's eye lens 13. Namely, the condenser lens 12 constitutes a so-called Fourier transform lens. The entrance surface of each lens element of the input fly's eye lens 11 is in a conjugate relation (imaging relation) with an entrance surface of each lens element of the fly's eye lens 13 corresponding thereto.

Therefore, incidence positions to the fly's eye lens 13, of the respective illumination light beams IL4a, IL4b emerging from the respective lens elements K1-K8 (which will be totally referred to as IL4c) are as follows.

Since each illumination light IL4c has no folding angle in the X-direction upon emergence from the lens element K1-K8, the X-directional position thereof is near the optical axis AX1 as shown in Fig. 7 (D).

On the other hand, since each illumination light IL4a, IL4b has a predetermined folding angle in the Y-direction upon emergence from the lens element K1-K8 because of the diffraction grating DG, the Y-directional position thereof is decentered in the Y-direction from the optical axis AX1 by an amount proportional to the folding angle, as shown in Fig. 7 (C), and therefore the illumination light beams are applied to the lens element F3.

Since the folding angles in the Y-direction of the respective illumination light beams emerging from the respective lens elements K1-K8 arrayed on the X-directional array position J3 are the same, as described above, the illumination light beams emerging from the respective lens elements K1-K8 all are applied in a superposed manner to the lens element F3.

Then the illumination light quantity distribution on the entrance surface of the lens element F3 is averaged and approximately uniformized by the superposition effect.

The folding characteristics of the diffraction gratings DG formed on the exit surfaces of the respective lens elements of the input fly's eye lens 11 are identical at the same X-directional array position, but they are different at the X-directional array positions thereof different from each other. Therefore, illumination light beams emerging from the respective lens elements at the same X-directional array position on the input fly's eye lens 11 all are incident in a superposed manner to the same lens element on the fly's eye lens 13, and illumination light quantity distributions thereof on the entrance surface are averaged and approximately uniformized by the superposition effect.

The input fly's eye lens 11 and condenser lens 12 can also be regarded as an optical system for limiting the illumination light beams incident to one lens element on the fly's eye lens 13, to illumination light distributed in a predetermined range in the X-direction, among the illumination light distributed in the predetermined plane on which the input fly's eye lens 11 is placed.

The illumination light distributed in the predetermined range in the X-direction on the input fly's eye lens 11 is incident at a predetermined angle of inclination in the X-direction to the predetermined lens element (e.g., F3) on the fly's eye lens 13. Since the lens element F3 is also a Fourier transform lens, a focal point (secondary light source) of these illumination light beams formed on the exit surface of the fly's eye lens 13 is shifted in the X-direction according to the predetermined incidence angle in the X-direction.

The incidence angles in the X-direction of the illumination light beams incident to the respective lens elements F1-F8 are different from each other as described above; thus the positions of the secondary light sources formed on the exit surface of the fly's eye lens 13 are shifted by a small amount in the X-direction for each of the lens elements F1-F8, and they are not formed on the same X-coordinate.

This X-directional variation in the positions of the respective secondary light sources will cause variation in the traveling directions in the X-direction of the respective illumination light beams forming the illumination light IL10, and, when a value of this variation is, for example, over the aforementioned tolerance (e.g., 2 [mrad]), it can also be a cause to lower the contrast of interference fringes formed on the wafer W.

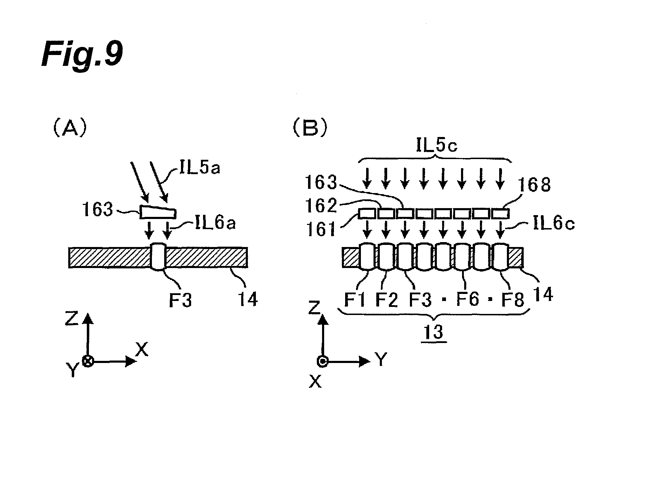

In order to cancel out this small shift, as shown in Fig. 9 (A) and Fig. 9 (B), the system may be provided with wedge prisms 161, 162, 163, 168 for folding the illumination light IL5a in the X-direction to align their traveling directions within the YZ plane, near the entrance surfaces of the respective lens elements F1-F8. Of course, wedge angles of the respective wedge prisms are angles different from each other.

This permits the illumination light IL6a to be incident normally in the X-direction to each lens element F1-F8 and permits the secondary light source group formed on the exit parts of the respective lens elements F1-F8 to be arrayed on the same X-coordinate.

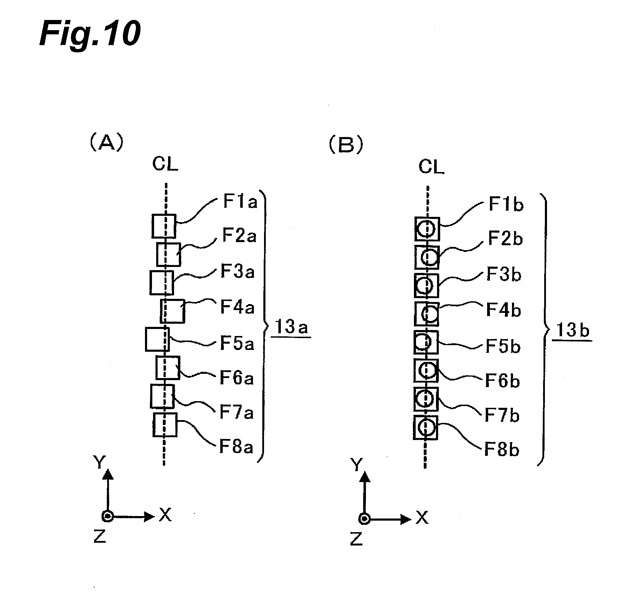

Alternatively, it is also possible to adopt another configuration, as shown in Fig. 10 (A), wherein the array is so arranged that each of lens elements F1a-F8a forming the fly's eye lens 13 is shifted by a small amount in the X-direction, whereby the secondary light source group focused on the exit surfaces thereof is formed on the same X-coordinate, i.e., on a dashed line CL in the drawing.

It is also possible to adopt still another configuration, as shown in Fig. 10 (B), wherein each of lens elements F1b-F8b forming the fly's eye lens 13 is composed of a lens whose lens center (center of each circle shown in the drawing) is decentered with respect to its contour, whereby the secondary light source group formed on the exit surfaces thereof is formed on the same X-coordinate, i.e., on a dashed line CL in the drawing.

The above means can reduce the X-directional variation in the secondary light source positions and reduce the X-directional variation in the traveling directions of the respective illumination light beams forming the illumination light IL10, to below the predetermined tolerance.

Such correction for the X-directional positions of the secondary light source group can be readily made because the illumination light incident to one of the lens elements F1-F8 forming the fly's eye lens 13 is limited to the illumination light distributed in the predetermined range in the X-direction, among the illumination light distributed in the predetermined plane where the input fly's eye lens 11 is placed, i.e., because it is limited to the illumination light within a certain range of incidence angles in the X-direction.

It is, however, noted that the above limitation does not always have to be perfect. The reason is that substantially the same effect can be achieved as long as most of the illumination light (e.g., 90% or more of the illumination light in terms of light quantity) out of the illumination light incident to one of the lens elements F1-F8 is the illumination light distributed in the predetermined range in the X-direction, among the illumination light distributed in the predetermined plane where the input fly's eye lens 11 is placed.

Since the diffraction gratings DG placed on the exit surface of the input fly's eye lens 11 also generate some stray light such as unwanted diffracted light, it can be said that it is difficult to perfectly prevent such stray light from entering the lens elements other than the desired one out of the lens elements F1-F8. It is, however, needless to mention that substantially the same effect can be achieved when the quantity of the stray light is not more than about 10% of the total quantity of the overall illumination light, as above.

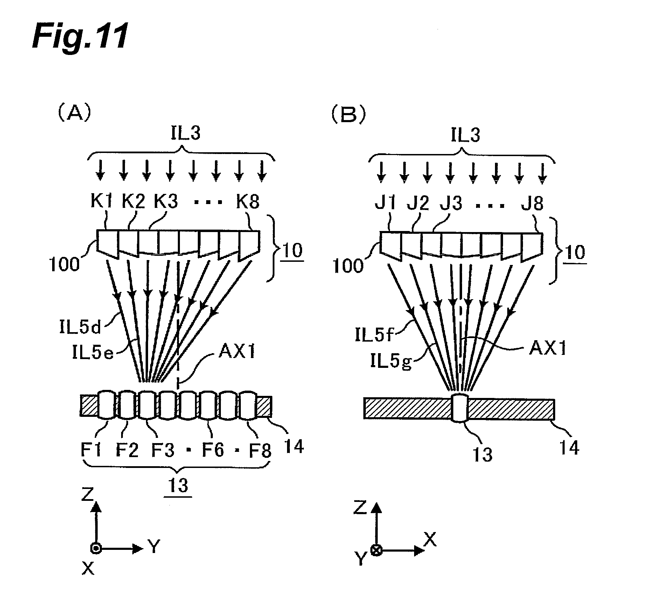

Embodiments of the condensing optical system 10 do not always have to be limited to this example, but it is also possible to adopt a prism array 100 in which taper angles of prism lenses are different from each other in a predetermined region in the XY plane, for example, as disclosed in Fig. 11.

The structure in the XY plane of the prism array 100 is one in which, for example, square prisms are two-dimensionally arrayed in the XY directions, as in the case of the input fly's eye lens 11 shown in Fig. 7 (A), but its cross section is one as shown in Fig. 11 (A) and Fig. 11 (B), in which the taper angles of the respective prisms vary according to the positions J1-J8 in each X-directional array and the positions K1-K8 in each Y-directional array.

The illumination light IL3 incident to the prism array 100 is subjected to the refraction action or folding action according to the taper angles, and is applied onto the predetermined lens elements F1-F8 on the fly's eye lens 13.

It is also needless to mention that in the present example the illumination light incident to one of the lens elements F1-F8 is preferably limited to illumination light from a prism group arrayed at the same X-directional array position on the prism array 100. The reason is that this arrangement permits us to readily adopt the techniques shown in Figs. 9 and 10, for forming the secondary light source group on the exit surface of the fly's eye lens 13, on the same X-coordinate.

Incidentally, there are no theoretical restrictions on lengths of the first effective distance L1 of the first diffraction grating G11 and the effective distance L2 between the second diffraction grating G21 and the wafer W themselves, but too long lengths of these effective distances L1, L2 could degrade the positional stability or contrast of the interference fringes formed on the wafer W because of influence of variation in the refractive index with air fluctuation in the optical path and thermal variation of the media.

On the other hand, when the first optically-transparent flat plate P1 for forming the first diffraction grating G11 and the second optically-transparent flat plate P1 for forming the second diffraction grating G21 are too thin, deflection or the like will occur, so as to fail to obtain good interference fringes.

In the present invention, therefore, the first effective distance L1 and the second effective distance L2 are so set, for example, as to be not less than 1mm and not more than 15 mm.
However, in order to form the light-dark pattern IF of interference fringes with higher accuracy, the first effective distance L1 and the second effective distance L2 both can be not less than 2 mm and not more than 10 mm.

Furthermore, in order to form the light-dark pattern IF of interference fringes with much higher accuracy, the first effective distance L1 and the second effective distance L2 both can be not less than 3 mm and not more than 7 mm. The lengths of the first effective distance L1 and the second effective distance L2 can be determined from the aforementioned stability and the stability required of the light-dark pattern of interference fringes.

Incidentally, in the case where the light-dark pattern IF of interference fringes with the one-dimensional period as described above is formed, the illumination light IL10 used for the formation is preferably linearly polarized light the polarization direction (direction of the electric field) of which is parallel to the longitudinal direction of the light-dark pattern IF, i.e., parallel to the longitudinal direction of the first diffraction grating G11 and the second diffraction grating G21. The reason is that the contrast of interference fringes IF becomes maximum in this case.

The illumination light IL10 does not always have to be the perfect linearly polarized light, but may be any illumination light the component of the electric field of which in the longitudinal direction (Y-direction) of the first diffraction grating G11 is greater than the component of the electric field in the direction of the period (X-direction), with the aforementioned contrast enhancing effect.

Such a polarization characteristic of the illumination light IL10 is realized by the light control element 9 provided in the illumination optical system. The light control element 9 is, for example, a polarization filter (sheet polarizer) or a polarization beam splitter arranged as rotatable around the optical axis AX1 as a rotation-axis direction, and rotation thereof enables the direction of polarization of the illumination light IL3 to be set to predetermined linear polarization.

When the light source 1 is a light source to radiate the illumination light IL 1 polarized approximately as linear polarized light like a laser beam, the light control element 9 to be used can be a half wave plate similarly arranged as rotatable. It is also possible to adopt two quarter wave plates arranged in series and as rotatable independently of each other. In this case, the polarization state of the illumination light IL3-IL10 can be set not only to approximately linearly polarized light, but also to circularly polarized light and elliptically polarized light.

It is needless to mention that in any one of the above-described illumination optical systems the range of irradiation with the illumination light IL10 does not have to encompass the entire surface of the first optically-transparent flat plate P1. Namely, it is sufficient that the illumination light IL10 is applied with a uniform intensity distribution in a predetermined region which includes the central part of the first diffraction grating G11 formed on the first optically-transparent flat plate P1 and by which the illumination light is transmitted to arrive on the wafer W.

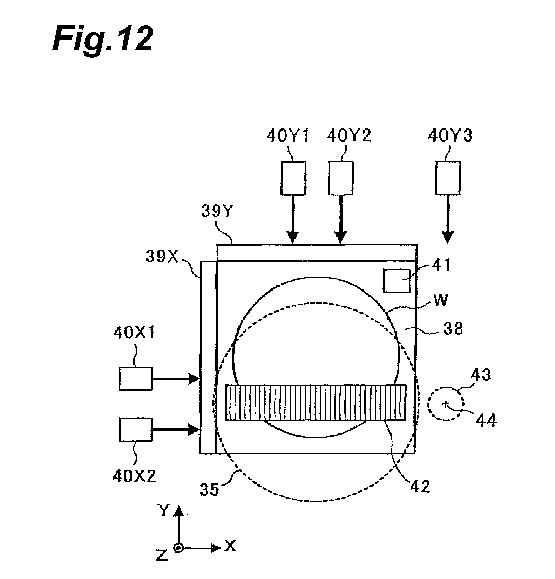

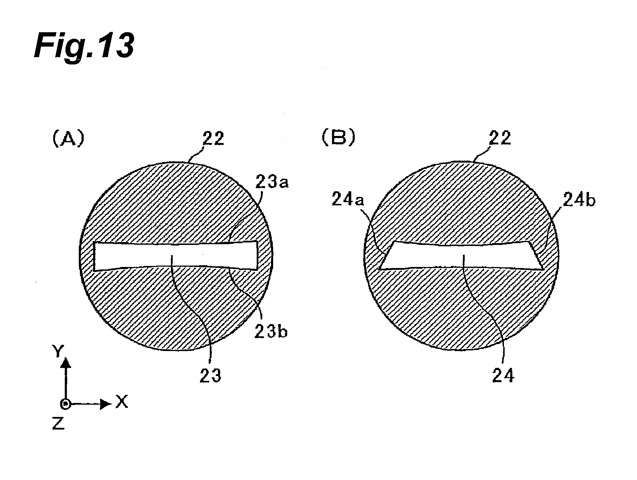

The range of irradiation with the illumination light IL10 does not have to be one encompassing the entire surface on the wafer W.
Another embodiment of the present invention will be described below with reference to Figs. 12 and 13.

Fig. 12 is a drawing schematically showing an exposure apparatus according to another embodiment of the present invention. However, since the light source 1, the illumination optical system IS, the first optically-transparent flat plate P1, and the second optically-transparent flat plate P2 are the same as those in the exposure apparatus shown in Fig. 1, they are omitted from the illustration, and only the condenser lens 35 is depicted by a dashed line.

In the present example, the region of the illumination light IL10 applied onto the first optically-transparent flat plate P1 is limited to an illumination region 42 smaller than the wafer W. However, the X-directional width of the illumination region 42 is larger than the diameter of the wafer W.

The exposure on the wafer W is effected by scanning the wafer W in the Y-direction by the wafer stage 35, relative to the light source 1, the illumination optical system IS, and the first and second optically-transparent flat plates P1, P2. Since the light-dark pattern IF of interference fringes having the period in the X-direction and the longitudinal direction along the Y-direction is formed on the wafer W by the illumination light IL10, the first diffraction grating G11 on the first optically-transparent flat plate P1, and the second diffraction grating G21 on the second optically-transparent flat plate P2, the scanning in the Y-direction is done along the longitudinal direction of the light-dark pattern IF of interference fringes.

On the occasion of the above-described scanning exposure, the X-directional and Y-directional positions and rotation of the wafer W are measured through X-moving mirror 39X and Y-moving mirror 39Y disposed on the wafer stage 38, by means of X-laser interferometers 40X1 and 40X2 and Y-laser interferometers 40Y1 and 40Y2, and controlled by an unrepresented stage control mechanism.

Since this scanning exposure results in exposing the wafer W to Y-directional accumulation of light-dark patterns IF formed by the first diffraction grating G11 and the second diffraction grating G21, influence of defects or foreign matter of these diffraction gratings is relaxed and a good pattern without defects is formed on the wafer W.

Concerning the nonuniformity of illuminance which could remain in the illumination region 42, errors thereof are also accumulated and averaged in the Y-direction whereby substantially higher uniformity can be realized. Furthermore, the shape of the illumination region 42 can also be one varying in the Y-directional width, depending upon positions in the X-direction. It is because this configuration changes the shape of the illumination region itself whereby Y-directional cumulative values can be made more uniformized in the illuminance distribution of illumination light in the illumination region 42.

Such shape of the illumination region 42 can be determined by the shape of the aperture 23 provided in the field stop 22 in the illumination optical system IS. The field stop 22 may be located near the light source side of the first optically-transparent substrate P1.

Fig. 13 (A) shows an example of shapes of the field stop 22 and aperture 23. Sides 23a, 23b defining the Y-directional two edges of the aperture 23 are curved lines and the spacing between them (Y-directional width) varies according to X-directional positions.

The illumination region 42 may be one the X-directional length of which is smaller than the diameter of the wafer W. In this case, the exposure of the light-dark pattern IF of interference fringes can also be implemented over the entire surface of the wafer W by repeatedly carrying out the aforementioned scanning exposure in the Y-direction while step-moving the wafer W in the X-direction.

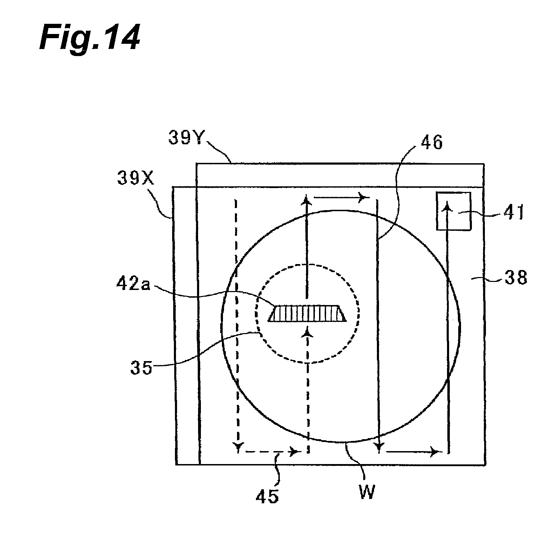

An exposure method of this type will be described below with reference to Fig. 14. Fig. 14 is a drawing schematically showing an exposure apparatus according to still another embodiment of the present invention. However, since the light source 1, the illumination optical system IS, the first optically-transparent flat plate P1, and the second optically-transparent flat plate P2 are the same as those in the exposure apparatus shown in Fig. 1, they are omitted from the illustration, and only the condenser lens 35 is depicted by a dashed line. The X-laser interferometers 40X1 and 40X2, Y-laser interferometers 40Y1 and 40Y2, and others are also omitted from the illustration because they are the same as those in the exposure apparatus shown in Fig. 12.

In the exposure apparatus of this example, the illumination region 42a has the X-directional length smaller than the diameter of the wafer W. Then the exposure on the wafer W is effected by step-moving the wafer W in the X-direction in combination with the Y-directional movement of the wafer W by the wafer stage 38 similar to that described above.

Specifically, the exposure is performed by combination of the scanning exposure in the Y-direction with the step movement in the X-direction during each duration between the scanning exposure operations so that the relative positional relation between the illumination region 42a and the wafer W is moved as indicated by dashed-line path 45 and solid-line path 46.

The number of scanning exposure operations in the Y-direction can be any number not less than 2, and the X-directional length of the illumination region 42a is set larger than a value obtained by dividing the diameter of the wafer W by the number of scanning exposure operations.

For joining patterns formed by adjacent Y-directional scanning exposure operations as described above, without positional deviation in the portion located at the X-directional border of the illumination region 42a, on the wafer W and for reducing influence of penumbral blur at the border of the illumination region 42a, the exposure is preferably implemented so that the illumination regions 42a in the two scanning exposure operations overlap each other to some extent.

Then the shape of the illumination region 42a can also be one varying in the X-directional width depending upon Y-directional positions. The illumination region 42a of this type can be formed by defining the shape of the aperture 24 in the field stop in the illumination optical system IS as shown in Fig. 13 (B).

Namely, the aperture is defined so that sides 24a, 24b defining the X-directional two edges of the aperture 24 are straight lines or curved lines not parallel to the Y-direction and that the spacing (X-directional width) between them varies according to Y-directional positions.

With the use of the illumination region 42a defined by such aperture 24, the exposure can be effected without positional deviation of the pattern and with less influence of penumbral blur, even in the region where the pattern is formed by joining of scanning exposures in the Y-direction on the wafer W.

The above-described Y-directional scanning and X-directional step movement both are implemented by moving the wafer W by the wafer stage 38, but it is also possible to adopt a configuration wherein the illumination optical system IS, the first optically-transparent substrate P1, and the second optically-transparent substrate P2 are integrally held and moved, contrary to the above. It is also possible to adopt a configuration wherein the wafer W and the first and second optically-transparent substrates P1, P2 are integrally held and relative scanning with the illumination optical system is implemented relative to them.

Instead of the scanning exposure as described above, it is also possible to effect multiple exposure consisting of exposure operations with step movements in the Y-direction and in the X-direction. In this case, a relative movement in the Y-direction between exposure operations can be made by an arbitrary length whereas a relative movement in the X-direction is limited to an integral multiple of the period T3 of the light-dark pattern of interference fringes formed on the wafer W.

It is generally the case that in a previous exposure step (photolithography step) a pattern is already formed on the wafer W to be exposed by the exposure apparatus, and in a new exposure step another pattern has to be formed while keeping a predetermined positional relation with the previous pattern.

The previous pattern on the wafer W often undergoes some expansion or contraction in comparison with the designed values by virtue of thermal deformation or stress deformation during film forming and etching steps on the wafer W.

Then the exposure apparatus is required to form the new pattern on the wafer W with some compensation by expansion or contraction, while adapting for such expansion or contraction of the wafer W.

The exposure apparatus of the present invention is adaptable to the compensation of expansion or contraction of the light-dark pattern formed on the wafer W, while changing either or both of the Z-position where the wafer W is set, and a convergence/divergence state of the illumination light IL10.

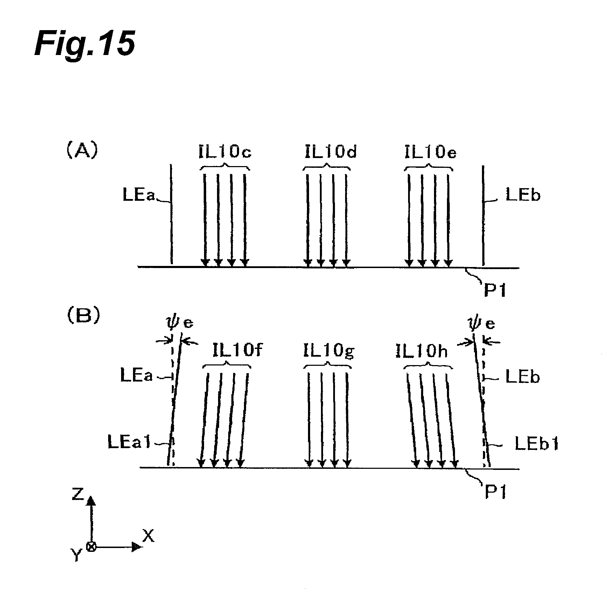

First, the convergence/divergence state of the illumination light IL10 will be described with Fig. 15.

Fig. 15 (A) is a drawing showing a state in which the illumination light IL10 is a bundle of parallel rays, or does not converge or diverge. The X-directional marginal ends LEa, LEb of the illumination region 42 or the like with the illumination light IL 10 are normal to the first optically-transparent flat plate P1 and illumination light beam IL10c, illumination light beam IL10d, and illumination light beam IL10e are incident normally to the first optically-transparent flat plate P1, irrespective of locations in the first optically-transparent flat plate P1.

On the other hand, Fig. 15 (B) is a drawing showing a case where the illumination light IL10 is a bundle of diverging rays, and the illumination light IL10 defined by the marginal rays LEa1, LEb1 travels in a diverging optical path as a whole. The marginal rays LEa1, LEb 1 at this time are inclined (diverging) each at $\varphi e$ from the vertical direction LEa, LEb. Therefore, the incidence angle of the illumination light IL10 to the first optically-transparent flat plate P1 varies according to locations therein.

Namely, an illumination light beam IL 10f applied through an optical path part near the marginal ray LEa1 is incident to the first optically-transparent flat plate P1 as slightly outwardly inclined. When the angle of inclination is defined as $\varphi f$, the light-dark pattern of interference fringes formed on the wafer W with the illumination light beam IL10f is formed at a position shifted by $\Delta Z \times \tan \varphi f$ according to Formula 10 in the - X-direction.

$\Delta Z$ herein is a difference of the second effective distance L2 between the wafer W and the second diffraction grating G21 from the first effective distance L1 between the first diffraction grating G11 and the second diffraction grating G21 as defined above. The reference position in the X-direction in the above is a position where the light-dark pattern of interference fringes is formed at $\varphi f = 0$.

On the other hand, the light-dark pattern of interference fringes formed on the wafer W with an illumination light beam IL10h applied through an optical path part near the marginal ray LEb 1 is formed at a position shifted by $\Delta Z \times \tan \varphi h$ according to Formula 10 in the + X-direction, using the outward inclination angle $\varphi h$ of the illumination light beam IL10h.

Furthermore, the position of the light-dark pattern of interference fringes formed on the wafer W with an illumination light beam IL10g applied through an optical path part near the center has no positional deviation because the illumination light beam IL10g is incident approximately normally.

Therefore, the magnitude relation of the interference fringe pattern IF formed on the wafer W, with the first diffraction grating G11 can be controlled as follows: when $\Delta Z$ is positive, the pattern can be enlarged by employing a diverging beam for the illumination light IL10, and the pattern can be reduced by employing a converging beam; therefore, it is feasible to implement the expansion or contraction compensation of the interference fringe pattern IF to be formed on the wafer W.

In the exposure apparatus of the present invention, as shown in Fig. 1, the negative lens 30 among the lenses 29, 30, 32, 35 forming the fourth lens group in the illumination optical system is provided with a lens drive mechanism 31a, 31b and the positive lens 32 is provided with a lens drive mechanism 33a, 33b. These lens drive mechanisms 31a, b, 33a, b are movable in the Z-direction on fixed shafts 34a, 34b, whereby the lens 30 and lens 32 are also movable independently of each other in the Z-direction.

Namely, the fourth lens group 29, 30, 32, 35 constitutes a so-called inner focus lens unit as a whole, and the focal length or focal position thereof is variable.

This permits the convergence/divergence state of the illumination light IL10 to be made variable.

In connection with it, the first lens group 2, 3, 4, 6 in the illumination optical system IS can also be provided with a Z- position adjusting mechanism so as to make the convergence/divergence state of the illumination light IL10 variable in combination with the aforementioned fourth lens group 29, 30, 32, 35.

In this configuration, as shown in Fig. 1, the negative lens 4 in the first lens group 2, 3, 4, 6 is provided with a lens drive mechanism 5a, 5b and the positive lens 6 is provided with a lens drive mechanism 7a, 7b. These lens drive mechanisms 5a, 5b, 7a, 7b are movable in the Z-direction on fixed shafts 8a, 8b, whereby the lens 4 and lens 6 are also movable independently of each other in the Z-direction.

It is also possible to implement the foregoing expansion or contraction compensation in the following manner: from Formula 10, the convergence/divergence state is fixed to a predetermined convergence state or divergence state without the variation as described above, and the Z-position where the wafer W is located is changed, i.e., the second effective distance L2 is changed relative to the first effective distance L1.

These expansion/contraction compensation methods are preferably carried out based on an expansion/contraction amount of the wafer W preliminarily measured by detecting positions of previous circuit patterns or alignment marks formed at a plurality of locations on the wafer W, by means of a wafer mark detecting mechanism 43, prior to the exposure on the wafer W.

It is also preferable to perform detection of a reference position of detection position 44 of the wafer mark detecting mechanism 43 with use of a reference mark 41 or the like on the wafer stage, prior to the measurement of the expansion/contraction amount of the wafer W or the like. It is also preferable that the exposure apparatus be provided with a detecting-mechanism laser interferometer 40Y3 or the like for enabling measurement of the position of the wafer stage 38 at the position of the wafer mark detecting mechanism 43, in order to improve the accuracy of the position measurement by the wafer mark detecting mechanism 43.

The wafer mark detecting mechanism 43 is also preferably provided with a Z-position sensor capable of measuring Z-positions including unevenness in the surface of the wafer W. This allows the following operation: the Z-position is measured for the surface of the wafer W, and the wafer stage 38 is driven in the Z-direction, based on the measured value, or a tilt control of the wafer stage 38 is further performed, thereby setting the second effective distance.

Of course, for example, the second holding mechanism 37a, 37b or the like may be provided with the foregoing Z-position sensor, separately from that of the wafer mark detecting mechanism 43.
Incidentally, the first diffraction grating G11 also generates the zero-order diffracted light (straight traveling light), in addition to the $\pm$ first-order diffracted light LM, LP being the aforementioned desired diffracted light. This zero-order diffracted light could further pass even through the second diffraction grating G21 to reach the wafer W. Such zero-order diffracted light, as stray light, would degrade the contrast of the desired light-dark pattern of interference fringes formed on the wafer W.

In the present invention, therefore, in order to block (absorb or reflect) this zero-order diffracted light, a diffracted light selecting member comprised of a multilayer interference filter or the like may be located between the first diffraction grating G11 and the second diffraction grating G21.

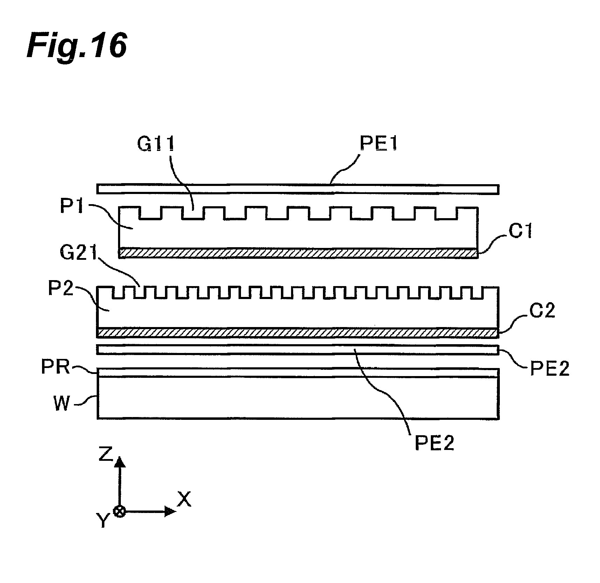

Fig. 16 is a drawing showing an example in which a diffracted light selecting member C1 is located on the surface of the first optically-transparent flat plate P1 on the side opposite to the first diffraction grating G11 and in which a diffracted light selecting member C2 is located on the surface of the second optically-transparent flat plate P2 on the side opposite to the second diffraction grating G21.

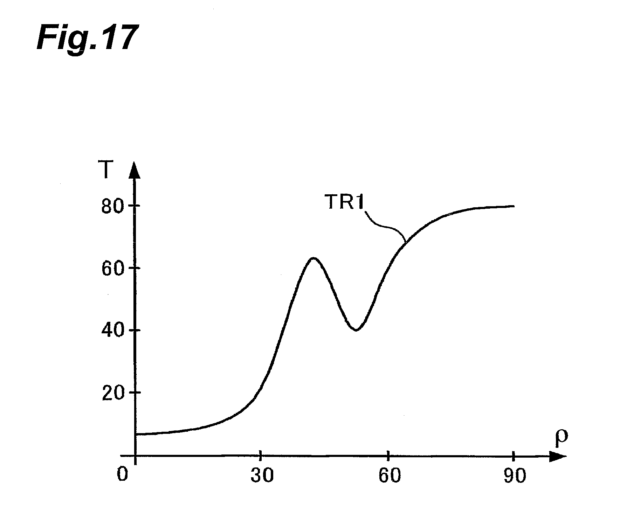

The transmittance characteristics of the diffracted light selecting members C1, C2 against incidence angles are as shown in Fig. 17. Specifically, the transmittance TR1 is low for rays incident at small incidence angles ρ to the diffracted light selecting members C1, C2 and high for rays incident at large incidence angles ρ.

This enables the diffracted light selecting members C1, C2 to change the transmittance for diffracted light incident thereto according to traveling directions thereof. Specifically, the transmittance for zero-order diffracted light emerging at small emergence angles from the first diffraction grating G11 can be made smaller than the transmittance for first-order diffracted light emerging at large emergence angles from the first diffraction grating G11. Therefore, it can reduce the quantity of zero-order diffracted light reaching the wafer W, and thus prevent reduction in the contrast of the desired light-dark pattern IF of interference fringes formed on the wafer W.

Such diffracted light selecting member C1, C2 can be realized, for example, by a thin film consisting of multiple layers in which oxide films with a high refractive index and oxide films with a low refractive index are alternately formed. It can also be realized by a thin film consisting of multiple layers in which fluoride films with a high refractive index and fluoride films with a low refractive index are alternately formed.

Incidentally, in order to reduce the adverse effect of foreign matter or the like adhering onto the first diffraction grating G11 and the second diffraction grating G21, it is also possible to locate thin films (pellicles) PE1, PE2 for prevention of adhesion of foreign matter to the first diffraction grating G11 and to the second diffraction grating G21, near the light source side of the first optically-transparent flat plate P1, or between the optically-transparent flat plate P2 and the wafer W, as shown in Fig. 16. The pellicles PE1, PE2 are replaced, for example, every exposure of a predetermined number of wafers W, thereby eliminating the foreign matter.

The pellicles PE1, PE2 to be used can be, for example, pellicles of organic resin used for prevention of adhesion of foreign matter to the reticle as used in the projection exposure apparatus.

In another example, the pellicles PE1, PE2 can be optically-transparent flat plates made of an inorganic material such as synthetic silica.

The above example showed the configuration wherein the first diffraction grating G11, G12 was the phase modulation type diffraction grating and the second diffraction grating G21 was the intensity modulation type diffraction grating, but configurations of the two diffraction gratings are not limited to it. For example, either or both of the two diffraction gratings can be diffraction gratings for modulating both the phase and intensity of transmitted light, like halftone phase shift reticles (Attenuated Phase Shift Masks).

The above example showed the configuration wherein the first diffraction grating G11, G12 and the second diffraction grating G21 were formed on their respective separate optically-transparent flat plates, but the two diffraction gratings can also be formed on a single optically-transparent flat plate.

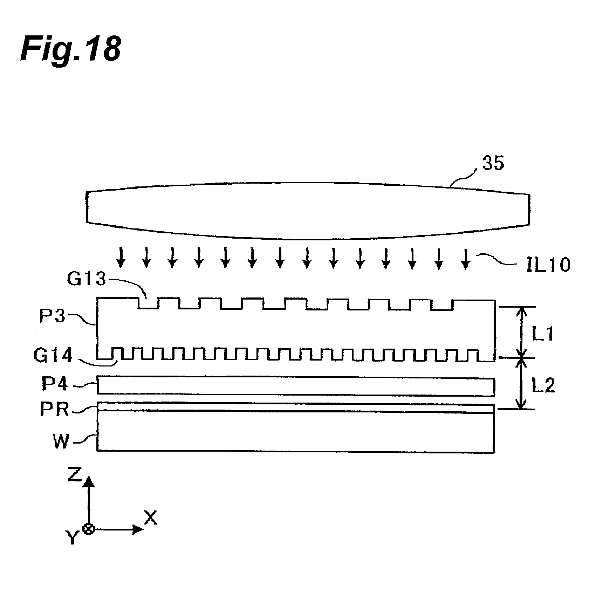

Fig. 18 is a drawing showing an example in which a first diffraction grating G13 and a second diffraction grating G14 are formed on the light source side and on the wafer W side, respectively, of a single optically-transparent flat plate P3. In this example, the structure and production process of each diffraction grating are much the same as in the aforementioned example. The lens 35 and the illumination optical system upstream thereof are also similar to those in the foregoing example.

An optically-transparent flat plate P4 in Fig. 18 is provided for preventing contamination of the second diffraction grating G14 and for making the first effective distance L1 and the second effective distance L2 equal to each other.

The first diffraction grating and second diffraction grating do not always have to be limited only to those on surfaces of optically-transparent flat plates.

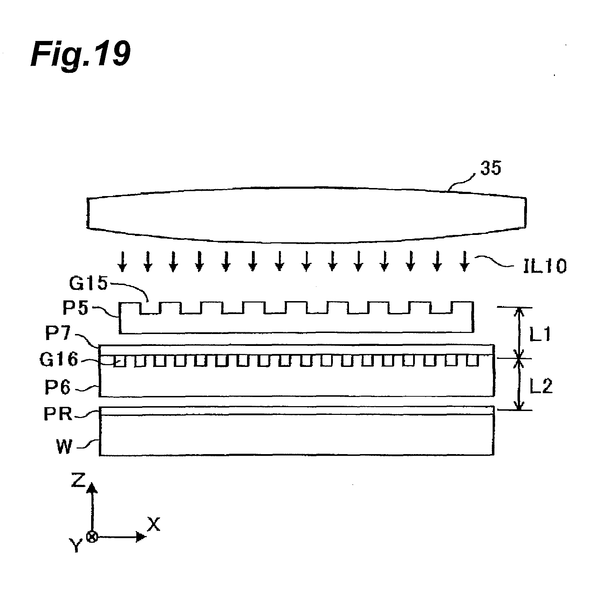

For example, as shown in Fig. 19, a second diffraction grating G16 is formed in a surface of a second optically-transparent flat plate P6 and a third thin optically-transparent flat plate P7 is bonded onto it, whereby the second diffraction grating G16 is formed effectively inside the optically-transparent flat plate. The second optically-transparent flat plate P5 and the first diffraction grating G15 in Fig. 19 are the same as those shown in Fig. 3.

In use of these optically-transparent flat plate P7 and others, the first effective distance L1 and the second effective distance L2 are also defined and determined similarly by the aforementioned method.

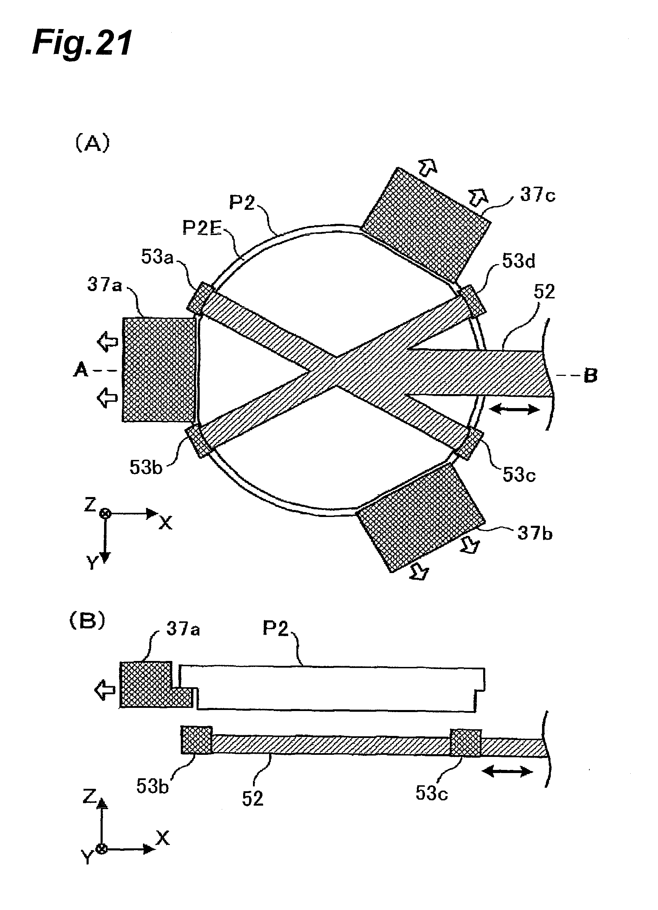

In any one of the above-described examples, the first diffraction grating G11 and the second diffraction grating G21 need to be replaced according to the period T3 of the light-dark pattern of interference fringes to be formed on the wafer W. Fig. 21 is a drawing showing an example of a replacing mechanism for the gratings, wherein Fig. 21 (A) is a view of the mechanism from the - Z-direction and Fig. 21 (B) a sectional view near part A-B in Fig. 21 (A).

A plate loader 52 is provided with chuck portions 53a, 53b, 53c, 53d for holding the peripheral part P2E of the second optically-transparent parallel plate P2 on which the second diffraction grating is provided, by such means as vacuum suction, and the plate loader 52 is slidable in the X-direction and vertically movable in the Z-direction.

Before the replacement, the second optically-transparent parallel plate P2 is held by a second holding mechanism 37a, 37b, 37c. In this state, the plate loader 52 is moved in the X-direction to below the second optically-transparent parallel plate P2 and then moved upward. Then the chuck portions 53a, 53b, 53c, 53d suck and hold the peripheral part P2E of the second optically-transparent parallel plate P2.

Thereafter, the second holding mechanism 37a, 37b, 37c is radially retracted as indicated by outline arrows in the drawing, and in that state the plate loader 42 is retracted in the + X-direction to carry the second optically-transparent parallel plate P2 away. Then another second optically-transparent parallel plate to be newly loaded is set on the second holding mechanism 37a, 37b, 37c through an operation reverse to the above operation, thereby completing the replacement of the second optically-transparent parallel plate.

A replacement mechanism for the first optically-transparent parallel plate P1 also has a configuration similar to the above.

Since the space is small between the first optically-transparent parallel plate P1 and the second optically-transparent parallel plate P2, it is difficult to put the plate loader into the space.

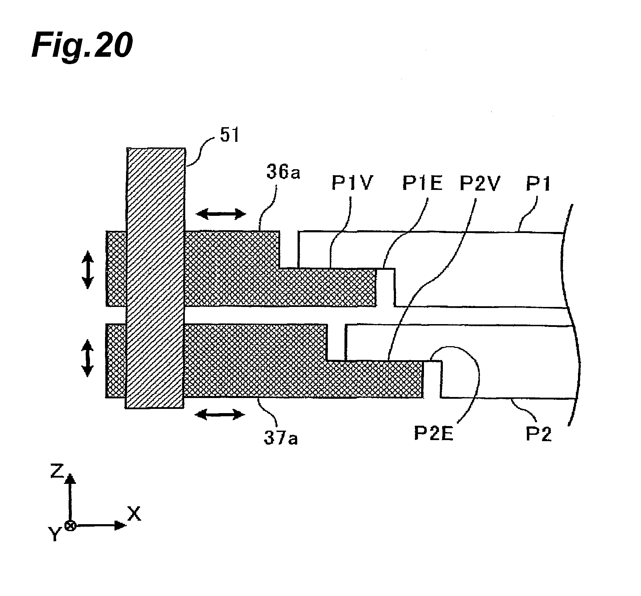

It is thus preferable to adopt a configuration, as shown in Fig. 20, wherein the first holding mechanism 36a and others and the second holding mechanism 37a and others are also supported by a support member 51 so as to be movable in the radial directions as directions in the XY planes and in the Z-directions. This allows the apparatus to ensure a clearance for loading of the plate loader.

The above-described Z-drive mechanism for the first holding mechanism 36a and others and the second holding mechanism 37a and others can also be used on the occasion of setting the second effective distance L2 between the second diffraction grating G21 and the wafer W and the first effective distance L1 between the first diffraction grating G11 and the second diffraction grating G21 to predetermined values.

As shown in Fig. 20, the peripheral part P1E of the first optically-transparent parallel plate P1 and the peripheral part P2E of the second optically-transparent parallel plate P2 are so stepped as to be smaller than the central parts thereof. A vacuum suction part P1V provided in the first holding mechanism 36a and others and a vacuum suction part P2V provided in the second holding mechanism 37a and others are arranged to hold the first optically-transparent parallel plate P1 and the second optically-transparent parallel plate P2 through these stepped peripheral parts P1E and PE2.

Incidentally, in the above examples air was present between the second optically-transparent flat plate P2 and the wafer W, but a predetermined dielectric may replace it to fill the space. This can reduce the substantial wavelength of illumination light (diffracted light) applied onto the wafer W, by the degree of the refractive index of the dielectric, whereby the period T3 of the light-dark pattern of interference fringes formed on the wafer W can be further reduced. It is needless to mention that, for implementing it, the period T2 of the second diffraction grating G21 and the period T1 of the first diffraction grating G11 need to be decreased in proportion thereto.

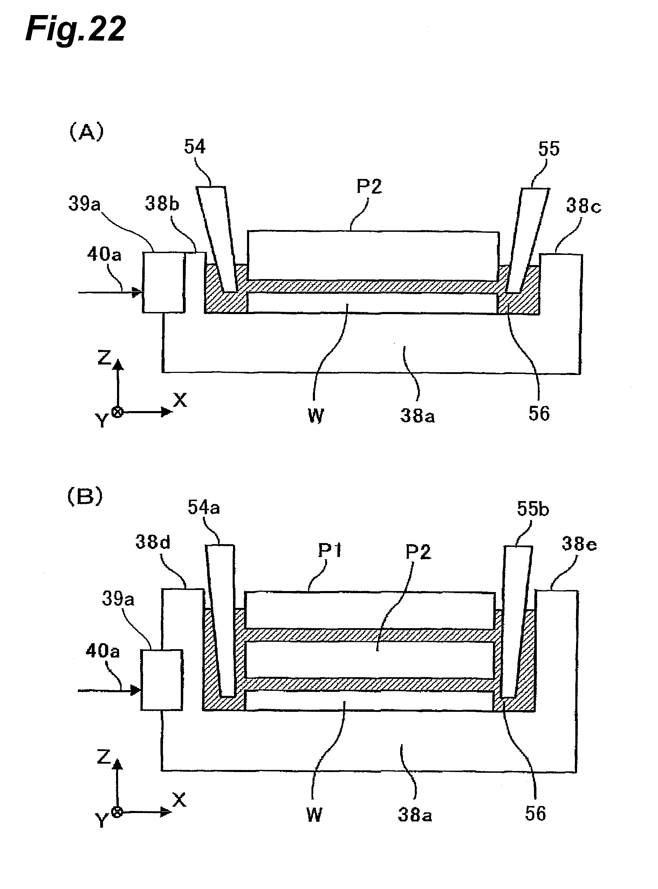

Fig. 22 (A) is a drawing showing an example of a wafer stage 38a and others suitable for it. A continuous side wall 38b, 38c is provided around the wafer stage 38a, so that a liquid 56 such as water can be reserved in a space surrounded by the side wall 38b, c. By this configuration, the space between the wafer W and the second optically-transparent flat plate P2 is filled with water, whereby the wavelength of the illumination light is decreased by the refractive index of water (1.46 for light of the wavelength 193 nm).

A water supply mechanism 54 and a water discharge mechanism 55 are also provided, so that fresh water without contamination can be supplied into and discharged from the space surrounded by the side wall 38b, c. It is also possible to adopt a configuration, as shown in Fig. 22 (B), wherein the top surface of the side wall 38d, 38e of the wafer stage 38a is set higher than the bottom surface of the first optically-transparent flat plate P1 and wherein the space between the first optically-transparent flat plate P1 and the second optically-transparent flat plate P2 is also filled with water. The functions of water supply mechanism 54a and the water discharge mechanism 55b are similar to those described above.

This permits the entire optical path from the first diffraction grating G11 to the wafer W to be covered with the dielectric except for air, whereby the effective wavelength $\lambda$ of the illumination light can be decreased by the degree of refraction of water. This enables exposure of a pattern with a finer period.

In the exposure apparatus shown in Fig. 22 (B), when the grating as shown in Fig. 3 is used for the second optically-transparent flat plate P2 and the second diffraction grating G21, water flows into the indentations of the second diffraction grating G21 to result in failure in achieving the desired phase difference, and thus the grating could fail to function as a phase grating. For the exposure apparatus of this type, it is preferable to use the second optically-transparent flat plate P6, the second diffraction grating G16, and the optically-transparent flat plate P7 as shown in Fig. 19. It is because the entry of water is practically prevented by use of the second diffraction grating G16 formed inside the optically-transparent flat plate, whereby the function of the phase grating can be ensured.

In another configuration the phase grating can be one in which high-index and low-index members are alternately and periodically arrayed in the first direction. This can be formed, for example, as follows: indentations are periodically formed on an optically-transparent flat plate of silica glass or the like, like the second diffraction grating G21 shown in Fig. 3, and the indentations of the grating are filled with a material with a refractive index different from that of the material of the optically-transparent flat plate. The material to be filled is preferably a material with the refractive index of not less than 1.8, in terms of establishment of an appropriate phase difference, when the optically-transparent flat plate used is made of a material with the refractive index of not more than 1.7 such as silica glass. It is also possible to make the phase grating by filling a high-index substrate such as sapphire with a low-index material.

The dielectric filled between the second optically-transparent flat plate P2 and the wafer W is not limited to water but may be another dielectric liquid, of course. In that case, the refractive index of the dielectric liquid is preferably not less than 1.2 in view of reduction in the period of the light-dark pattern of interference fringes.

In the exposure apparatus of the present invention the various optically-transparent flat plates are arranged in proximity along the optical path, and thus it could cause adverse effect due to multiple interference in conjunction with surface reflection on each surface.

In the present invention, therefore, the illumination light IL1-IL 10 from the light source 1 is preferably light with the temporal coherence length (coherence length in the traveling direction of light) of not more than 100 [$\mu$m]. This can avoid generation of unwanted interference fringes due to the multiple interference.

The temporal coherence length of light is a distance approximately represented by $\lambda^2/\Delta\lambda$, where $\lambda$ is the wavelength of the light and $\Delta\lambda$ a half width of wavelengths in a wavelength distribution of the light. Therefore, where the exposure wavelength $\lambda$ is 193 nm from the ArF laser, it is desirable to use the illumination light IL1-IL10 with the wavelength half width $\Delta\lambda$ of not less than about 370 pm.

For the wavelength of the illumination light IL1-IL10, it is desirable to use illumination light of not more than 200 [nm], in order to obtain a finer interference fringe pattern IF.

The wafer W after the exposure of the light-dark pattern of the interference fringes as described above is carried out of the exposure apparatus by an unrepresented wafer loader and carried to a developing apparatus. The development results in forming a resist pattern according to the printed light-dark pattern in the photoresist on the wafer W. Then an etching system is used to etch the wafer W or a predetermined film formed on the wafer W, using the resist pattern as an etching mask, to form a predetermined pattern in the wafer W.

Steps of manufacturing electronic devices such as semiconductor integrated circuits, flat panel displays, thin-film magnetic heads, and micro machines include steps of forming a fine pattern as described above, in a large number of layers. The above-described exposure method by the exposure apparatus of the present invention can be used in at least one step among the steps of forming the large number of patterns, to manufacture the electronic devices.

In the at least one step, combined exposure with a pattern of a predetermined shape made with an ordinary projection exposure apparatus can be effected on a photoresist PR on the wafer W after the exposure of the light-dark pattern of interference fringes by the above-described exposure method by the exposure apparatus of the present invention, and the photoresist PR after the combined exposure is then developed, to form the above pattern.

The present invention, without having to be limited to the above-described embodiments, can be modified in various ways without departing from the scope and spirit of the present invention. The entire disclosure in Japanese Patent Application No. 2005-052158 filed on February 25, 2005, including the specification, scope of claims, drawings, and abstract, is incorporated herein by reference in its entirety.

**Industrial Applicability**

The exposure method of the present invention can be carried out in the manufacture of the electronic devices such as the semiconductor integrated circuits, flat panel displays, thin-film magnetic heads, and micro machines, and is thus industrially applicable.

The exposure apparatus of the present invention can be carried out in the manufacture of the electronic devices such as the semiconductor integrated circuits, flat panel displays, thin-film magnetic heads, and micro machines, and is thus industrially applicable.

The electronic device manufacturing method and the electronic devices of the present invention are applicable in the industries in the manufacturing process, i.e., in industries of producing semiconductors, and the electronic devices as products are applicable in various electronic equipment industries.

**Claims**

1.  An exposure method of effecting exposure of a pattern on a photosensitive substrate with illumination light from a light source, the exposure method comprising:

    a step of applying the illumination light onto a first diffraction grating which has a direction of a period in a first direction and a longitudinal direction in a second direction perpendicular to the first direction;
    a step of applying diffracted light from the first diffraction grating, onto a second diffraction grating which is located at a first effective distance and on the opposite side to the light source from the first diffraction grating and which has a direction of a period in the first direction; and
    a step of applying diffracted light from the second diffraction grating, onto the photosensitive substrate located at a second effective distance substantially equal to the first effective distance and on the opposite side to the first diffraction grating from the second diffraction grating;

    wherein a principal component of the illumination light applied onto a predetermined point on the first diffraction grating comprises a plurality of illumination light beams having respective traveling directions substantially in correspondence with a specific plane which includes the second direction and which is substantially normal to the first diffraction grating.

2.  The exposure method according to claim 1, wherein an effective angle of a deviation from a direction in the specific plane, of the traveling directions of the principal component of the illumination light applied onto the first diffraction grating is within 1 [mrad].

3.  The exposure method according to claim 1, wherein while a relative positional relation in in-plane directions of the substrate, of the first diffraction grating and the second diffraction grating with the substrate is shifted in the second direction, or shifted in the first direction by a length equal to an integral or half-integral multiple of the period of the second diffraction grating, said steps are repeatedly carried out plural times.

4.  The exposure method according to claim 1, wherein said steps are carried out by scanning exposure to effect the exposure while causing a relative scan of the first diffraction grating and the second diffraction grating to the substrate in the second direction.

5. The exposure method according to claim 4, wherein a shape of a region where the illumination light is applied on the substrate, varies in a width in the second direction, depending upon positions in the first direction.

6. The exposure method according to claim 4, wherein said scanning exposure comprises a plurality of scanning exposure operations and in each of durations between the plurality of scanning exposure operations, a relative movement of the first diffraction grating and the second diffraction grating to the substrate is caused in the first direction.

7. The exposure method according to claim 6, wherein a shape of a region where the illumination light is applied on the substrate, varies in a width in the first direction, depending upon positions in the second direction.

8. An exposure method of effecting exposure of a pattern on a photosensitive substrate with illumination light from a light source, the exposure method comprising:

   a step of applying the illumination light onto a first diffraction grating which has a direction of a period in a first direction and a longitudinal direction in a second direction perpendicular to the first direction;
   a step of applying diffracted light from the first diffraction grating, onto a second diffraction grating which is located at a first effective distance and on the opposite side to the light source from the first diffraction grating and which has a direction of a period in the first direction; and
   a step of applying diffracted light from the second diffraction grating, onto the photosensitive substrate located at a second effective distance substantially equal to the first effective distance and on the opposite side to the first diffraction grating from the second diffraction grating;

   wherein a range of effective incidence angles of the illumination light applied onto a predetermined point on the first diffraction grating
   is not more than 2 [mrad] in the first direction, and
   is more than 2 [mrad] in the second direction.

9. The exposure method according to claim 8, wherein the range of effective incidence angles of the illumination light applied onto the predetermined point on the first diffraction grating
   is not more than 1 [mrad] in the first direction, and
   is more than 5 [mrad] in the second direction.

10. The exposure method according to claim 8, wherein while a relative positional relation in in-plane directions of the substrate, of the first diffraction grating and the second diffraction grating with the substrate is shifted in the second direction, or shifted in the first direction by a length equal to an integral or half-integral multiple of the period of the second diffraction grating, said steps are repeatedly carried out plural times.

11. The exposure method according to claim 8, wherein said steps are carried out by scanning exposure to effect the exposure while causing a relative scan of the first diffraction grating and the second diffraction grating to the substrate in the second direction.

12. The exposure method according to claim 11, wherein a shape of a region where the illumination light is applied on the substrate, varies in a width in the second direction, depending upon positions in the first direction.

13. The exposure method according to claim 11, wherein said scanning exposure comprises a plurality of scanning exposure operations and in each of durations between the plurality of scanning exposure operations, a relative movement of the first diffraction grating and the second diffraction grating to the substrate is caused in the first direction.

14. The exposure method according to claim 13, wherein a shape of a region where the illumination light is applied on the substrate, varies in a width in the first direction, depending upon positions in the second direction.

15. An exposure method of effecting exposure of a pattern on a photosensitive substrate with illumination light from a light source, the exposure method comprising:

   a step of applying the illumination light onto a first diffraction grating which has a direction of a period in a first direction and a longitudinal direction in a second direction perpendicular to the first direction;

a step of applying diffracted light from the first diffraction grating, onto a second diffraction grating which is located at a first effective distance and on the opposite side to the light source from the first diffraction grating and which has a direction of a period in the first direction; and

a step of applying diffracted light from the second diffraction grating, onto the photosensitive substrate located at a second effective distance substantially equal to the first effective distance and on the opposite side to the first diffraction grating from the second diffraction grating;

wherein a diffracted light selecting member having transmittances for the diffracted light varying according to traveling directions of the diffracted light is disposed on an optical path between the first diffraction grating and the substrate.

16. The exposure method according to claim 15, wherein the diffracted light selecting member is disposed between the first diffraction grating and the second diffraction grating.

17. The exposure method according to claim 16, wherein the transmittances of the diffracted light selecting member are low for the diffracted light emerging at a small angle of emergence from the first diffraction grating and high for the diffracted light emerging at a large angle of emergence from the first diffraction grating.

18. The exposure method according to claim 15, wherein the diffracted light selecting member is disposed between the second diffraction grating and the substrate.

19. The exposure method according to claim 18, wherein the transmittances of the diffracted light selecting member are low for the diffracted light emerging at a small angle of emergence from the second diffraction grating and high for the diffracted light emerging at a large angle of emergence from the second diffraction grating.

20. The exposure method according to claim 15, wherein the diffracted light selecting member includes a multilayer film structure of a dielectric having a relatively high refractive index for the illumination light and a dielectric having a relatively low refractive index for the illumination light.

21. The exposure method according to claim 15, wherein while a relative positional relation in in-plane directions of the substrate, of the first diffraction grating and the second diffraction grating with the substrate is shifted in the second direction, or shifted in the first direction by a length equal to an integral or half-integral multiple of the period of the second diffraction grating, said steps are repeatedly carried out plural times.

22. The exposure method according to claim 15, wherein said steps are carried out by scanning exposure to effect the exposure while causing a relative scan of the first diffraction grating and the second diffraction grating to the substrate in the second direction.

23. The exposure method according to claim 22, wherein a shape of a region where the illumination light is applied on the substrate, varies in a width in the second direction, depending upon positions in the first direction.

24. The exposure method according to claim 22, wherein said scanning exposure comprises a plurality of scanning exposure operations and in each of durations between the plurality of scanning exposure operations, a relative movement of the first diffraction grating and the second diffraction grating to the substrate is caused in the first direction.

25. The exposure method according to claim 24, wherein a shape of a region where the illumination light is applied on the substrate, varies in a width in the first direction, depending upon positions in the second direction.

26. The exposure method according to any one of claims 1 to 25, wherein the first effective distance and the second effective distance both are not less than 1 mm and not more than 15 mm.

27. The exposure method according to any one of claims 1 to 25, wherein the first effective distance and the second effective distance both are not less than 2 mm and not more than 10 mm.

28. The exposure method according to any one of claims 1 to 25, wherein the first effective distance and the second effective distance both are not less than 3 mm and not more than 7 mm.

29. The exposure method according to any one of claims 1 to 25, wherein a difference between the first effective distance and the second effective distance is not more than 100 $\mu$m.

30. The exposure method according to any one of claims 1 to 25, wherein a difference between the first effective distance and the second effective distance is not more than 30 $\mu$m.

31. The exposure method according to any one of claims 1 to 25, wherein at least one of the first effective distance and the second effective distance, or a difference between the first effective distance and the second effective distance is determined according to a convergence/divergence state in the first direction of the illumination light applied onto the substrate, and expansion/contraction of the substrate, or further according to a predetermined condition.

32. The exposure method according to any one of claims 1 to 25, wherein a convergence/divergence state in the first direction of the illumination light applied onto the first diffraction grating is determined according to the first effective distance and the second effective distance, expansion/contraction of the substrate, or a predetermined condition.

33. The exposure method according to any one of claims 1 to 25, wherein the period of the first diffraction grating is substantially twice the period of the second diffraction grating.

34. The exposure method according to any one of claims 1 to 25, wherein the period of the first diffraction grating is substantially equal to the period of the second diffraction grating.

35. The exposure method according to any one of claims 1 to 25, wherein the periods of the first diffraction grating and the second diffraction grating are not less than half and not more than three times an effective wavelength of the illumination light.

36. The exposure method according to any one of claims 1 to 25, wherein at least either the first diffraction grating or the second diffraction grating is a phase modulation type diffraction grating to modulate a phase of transmitted light.

37. The exposure method according to any one of claims 1 to 25, wherein said illumination light applied onto the first diffraction grating is illumination light a component of an electric field of which in the second direction is greater than a component of the electric field in the first direction.

38. The exposure method according to any one of claims 1 to 25, wherein an optically-transparent flat plate or thin film is disposed at least either near the light source side of the first diffraction grating, or near the first diffraction grating side of the second diffraction grating side.

39. The exposure method according to any one of claims 1 to 25, wherein at least either an optical path between the second diffraction grating and the substrate or an optical path between the first diffraction grating and the substrate is filled with a dielectric having a refractive index of not less than 1.2 at a wavelength of the exposure.

40. The exposure method according to claim 39, wherein a part of the dielectric is a liquid.

41. The exposure method according to claim 40, wherein the liquid is water.

42. The exposure method according to claim 39, wherein the second diffraction grating includes a space with a refractive index of not more than 1.1 disposed in a dielectric with a refractive index of not less than 1.3.

43. The exposure method according to claim 39, wherein at least either the first diffraction grating or the second diffraction grating includes a grating portion in which dielectrics with a refractive index of not more than 1.7 and dielectrics with a refractive index of not less than 1.8 are periodically arrayed in the first direction.

44. The exposure method according to any one of claims 1 to 25, wherein a temporal coherence length of the illumination light is not more than 100 $\mu$m.

45. An electronic device manufacturing method wherein the exposure method as defined in any one of claims 1 to 25 is used in at least one of steps of forming a circuit pattern for making up an electronic device.

46. An electronic device manufacturing method wherein the exposure method as defined in claim 39 is used in at least one of steps of forming a circuit pattern for making up an electronic device.

47. An electronic device manufacturing method wherein the exposure method as defined in claim 43 is used in at least one of steps of forming a circuit pattern for making up an electronic device.

48. An electronic device manufacturing method wherein combined exposure of a projection exposure method using a projection exposure apparatus, and the exposure method as defined in any one of claims 1 to 25 is used in at least one of steps of forming a circuit pattern for making up an electronic device.

49. An electronic device manufacturing method wherein combined exposure of a projection exposure method using a projection exposure apparatus, and the exposure method as defined in claim 39 is used in at least one of steps of forming a circuit pattern for making up an electronic device.

50. An electronic device manufacturing method wherein combined exposure of a projection exposure method using a projection exposure apparatus, and the exposure method as defined in claim 43 is used in at least one of steps of forming a circuit pattern for making up an electronic device.

51. An exposure apparatus for effecting exposure on a photosensitive substrate, of an interference pattern generated by a first diffraction grating and a second diffraction grating with illumination light from a light source, said exposure apparatus comprising:

   a first holding mechanism for holding the first diffraction grating substantially in correspondence with a first plane while keeping a direction of a period of the first diffraction grating coincident with a first direction and a longitudinal direction of the first diffraction grating coincident with a second direction perpendicular to the first direction;
   a second holding mechanism for holding the second diffraction grating substantially in correspondence with a second plane located at a first effective distance and on the opposite side to the light source from the first plane while keeping a direction of a period of the second diffraction grating coincident with the first direction and a longitudinal direction of the second diffraction grating coincident with the second direction;
   a substrate holding mechanism for holding the substrate substantially in correspondence with a third plane located on the opposite side to the first plane and at a second effective distance substantially equal to the first effective distance from the second plane; and
   an illumination optical system for applying the illumination light from the light source onto the first plane, wherein a principal component of the illumination light applied onto a predetermined point in the first plane comprises a plurality of illumination light beams having respective traveling directions substantially in correspondence with a specific plane which includes the second direction and which is substantially normal to the first plane.

52. The exposure apparatus according to claim 51, wherein an effective angle of a deviation from a direction in the specific plane, of the traveling directions of the principal component of the illumination light applied onto the first plane is within 1 [mrad].

53. The exposure apparatus according to claim 51, wherein either the first holding mechanism and the second holding mechanism, or the substrate holding mechanism comprises at least either a moving mechanism for causing a relative movement in the first direction or a scanning mechanism for causing a relative movement in the second direction, for a relative positional relation of the first diffraction grating and the second diffraction grating to the substrate.

54. The exposure apparatus according to claim 53, wherein a shape of a region illuminated with the illumination light on the first plane varies at least either in a width in the second direction, depending upon positions in the first direction, or in a width in the first direction, depending upon positions in the second direction.

55. The exposure apparatus according to claim 54, wherein the shape of the illuminated region is determined by a shape of a field stop disposed near the first plane or, on or near a plane conjugate with the first plane.

56. An exposure apparatus for effecting exposure on a photosensitive substrate, of an interference pattern generated by a first diffraction grating and a second diffraction grating with illumination light from a light source, said exposure apparatus comprising:

   a first holding mechanism for holding the first diffraction grating substantially in correspondence with a first plane while keeping a direction of a period of the first diffraction grating coincident with a first direction and a longitudinal direction of the first diffraction grating coincident with a second direction perpendicular to the first direction;
   a second holding mechanism for holding the second diffraction grating substantially in correspondence with a second plane located at a first effective distance and on the opposite side to the light source from the first plane while keeping a direction of a period of the second diffraction grating coincident with the first direction and a longitudinal direction of the second diffraction grating coincident with the second direction;

a substrate holding mechanism for holding the substrate substantially in correspondence with a third plane located on the opposite side to the first plane and at a second effective distance substantially equal to the first effective distance from the second plane; and

an illumination optical system for applying the illumination light from the light source onto the first plane, wherein a range of effective incidence angles of the illumination light applied onto a predetermined point in the first plane

is not more than 2 [mrad] in the first direction, and

is more than 2 [mrad] in the second direction.

57. The exposure apparatus according to claim 56, wherein the range of effective incidence angles of the illumination light applied onto the predetermined point on the first plane

is not more than 1 [mrad] in the first direction, and

is more than 5 [mrad] in the second direction.

58. The exposure apparatus according to claim 56, wherein either the first holding mechanism and the second holding mechanism, or the substrate holding mechanism comprises at least either a moving mechanism for causing a relative movement in the first direction or a scanning mechanism for causing a relative movement in the second direction, for a relative positional relation of the first diffraction grating and the second diffraction grating to the substrate.

59. The exposure apparatus according to claim 58, wherein a shape of a region illuminated with the illumination light on the first plane varies at least either in a width in the second direction, depending upon positions in the first direction, or in a width in the first direction, depending upon positions in the second direction.

60. The exposure apparatus according to claim 59, wherein the shape of the illuminated region is determined by a shape of a field stop disposed near the first plane or, on or near a plane conjugate with the first plane.

61. An exposure apparatus for effecting exposure on a photosensitive substrate, of an interference pattern generated by a first diffraction grating and a second diffraction grating with illumination light from a light source, said exposure apparatus comprising:

a first holding mechanism for holding the first diffraction grating substantially in correspondence with a first plane while keeping a direction of a period of the first diffraction grating coincident with a first direction and a longitudinal direction of the first diffraction grating coincident with a second direction perpendicular to the first direction;

a second holding mechanism for holding the second diffraction grating substantially in correspondence with a second plane located at a first effective distance and on the opposite side to the light source from the first plane while keeping a direction of a period of the second diffraction grating coincident with the first direction and a longitudinal direction of the second diffraction grating coincident with the second direction;

a substrate holding mechanism for holding the substrate substantially in correspondence with a third plane located on the opposite side to the first plane and at a second effective distance substantially equal to the first effective distance from the second plane;

an illumination optical system for applying the illumination light from the light source onto the first plane; and

a third holding mechanism for holding a diffracted light selecting member having transmittances for the diffracted light varying according to traveling directions of the diffracted light, substantially in correspondence with a fourth plane between the first plane and the third plane.

62. An exposure apparatus for effecting exposure on a photosensitive substrate, of an interference pattern generated by a first diffraction grating and a second diffraction grating with illumination light from a light source, said exposure apparatus comprising:

a first holding mechanism for holding the first diffraction grating substantially in correspondence with a first plane while keeping a direction of a period of the first diffraction grating coincident with a first direction and a longitudinal direction of the first diffraction grating coincident with a second direction perpendicular to the first direction;

a second holding mechanism for holding the second diffraction grating substantially in correspondence with a second plane located at a first effective distance and on the opposite side to the light source from the first plane while keeping a direction of a period of the second diffraction grating coincident with the first direction and a longitudinal direction of the second diffraction grating coincident with the second direction;

28

a substrate holding mechanism for holding the substrate substantially in correspondence with a third plane located on the opposite side to the first plane and at a second effective distance substantially equal to the first effective distance from the second plane;

an illumination optical system for applying the illumination light from the light source onto the first plane; and

a diffracted light selecting member located between the first plane and the third plane and having transmittances for the diffracted light varying according to traveling directions of the diffracted light.

63. The exposure apparatus according to claim 62, wherein the diffracted light selecting member is disposed at least either between the first plane and the second plane, or between the second plane and the third plane.

64. The exposure apparatus according to claim 62, wherein the transmittances of the diffracted light selecting member are low for light incident at a small angle of incidence to the diffracted light selecting member and high for light incident at a large angle of incidence to the diffracted light selecting member.

65. The exposure apparatus according to claim 62, wherein the diffracted light selecting member includes a multilayer film structure of a dielectric having a relatively high refractive index for the illumination light and a dielectric having a relatively low refractive index for the illumination light.

66. The exposure apparatus according to any one of claims 51 to 65, wherein the illumination optical system comprises illumination light uniformizing means for substantially uniformizing an intensity distribution of the illumination light in the first plane.

67. The exposure apparatus according to claim 66, wherein the illumination light uniformizing means comprises at least one fly's eye lens in which lens elements are arrayed along the second direction.

68. The exposure apparatus according to claim 67, wherein the illumination light uniformizing means comprises a condensing optical system for substantially limiting illumination light incident to an arbitrary lens element in said at least one fly's eye lens, to illumination light distributed in a predetermined range in the first direction, among illumination light distributed in a predetermined plane on the light source side of the fly's eye lens in the illumination light uniformizing means.

69. The exposure apparatus according to claim 67, wherein the illumination light uniformizing means comprises secondary illuminant position correcting means for arraying a plurality of secondary light sources formed on an exit surface of said at least one fly's eye lens, substantially on a line parallel to the second direction.

70. The exposure apparatus according to any one of claims 51 to 65, wherein the first effective distance and the second effective distance both are not less than 1 mm and not more than 15 mm.

71. The exposure apparatus according to any one of claims 51 to 65, wherein the first effective distance and the second effective distance both are not less than 2 mm and not more than 10 mm.

72. The exposure apparatus according to any one of claims 51 to 65, wherein the first effective distance and the second effective distance both are not less than 3 mm and not more than 7 mm.

73. The exposure apparatus according to any one of claims 51 to 65, wherein a difference between the first effective distance and the second effective distance is not more than 100 $\mu$m.

74. The exposure apparatus according to any one of claims 51 to 65, wherein a difference between the first effective distance and the second effective distance is not more than 30 $\mu$m.

75. The exposure apparatus according to any one of claims 51 to 65, wherein at least one of the first effective distance and the second effective distance, or a difference between the first effective distance and the second effective distance is determined according to a convergence/divergence state in the first direction of the illumination light applied onto the first plane, and expansion/contraction of the substrate, or further according to a predetermined condition..

76. The exposure apparatus according to claim 75, comprising an expansion/contraction measuring mechanism for measuring expansion/contraction of the substrate.

**77.** The exposure apparatus according to claim 75, wherein the second effective distance can be changed by adjusting a position of the third plane on which the substrate holding mechanism holds the substrate.

**78.** The exposure apparatus according to any one of claims 51 to 65, wherein a convergence/divergence state in the first direction of the illumination light applied onto the first plane is determined according to the first effective distance and the second effective distance, expansion/contraction of the substrate, or a predetermined condition.

**79.** The exposure apparatus according to claim 78, comprising an expansion/contraction measuring mechanism for measuring expansion/contraction of the substrate.

**80.** The exposure apparatus according to any one of claims 51 to 65, comprising, in the illumination optical system, a polarization control member for defining a magnitude relation between a component of an electric field in the first direction and a component of the electric field in the second direction, of the illumination light applied onto the first plane.

**81.** The exposure apparatus according to any one of claims 51 to 65, comprising a liquid supply mechanism for filling at least either at least a part of a space between the first plane and the third plane, or at least a part of a space between the second plane and the third plane, with a dielectric liquid having a refractive index of not less than 1.2 at a wavelength of the exposure.

**82.** The exposure apparatus according to claim 81, wherein the dielectric liquid is water.

**83.** The exposure apparatus according to any one of claims 51 to 65, wherein a temporal coherence length of the illumination light is not more than 100 $\mu$m.

**84.** The exposure apparatus according to any one of claims 51 to 60, comprising a diffracted light selecting member located between the first plane and the third plane and having transmittances for the diffracted light varying according to traveling directions of the diffracted light.

**85.** An illumination optical apparatus for applying illumination light from a light source onto a predetermined surface to be illuminated,
wherein a range of effective incidence angles of the illumination light applied onto a predetermined point on the surface to be illuminated
is not more than 2 [mrad] in a first direction in the surface to be illuminated, and
is a value of more than 2 [mrad] in a second direction perpendicular to the first direction in the surface to be illuminated,
said illumination optical apparatus comprising a field stop for restricting a shape of the illumination light applied onto the surface to be illuminated, to a predetermined shape.

**86.** The illumination optical apparatus according to claim 85,
wherein the range of effective incidence angles of the illumination light applied onto the predetermined point on the first plane
is not more than 1 [mrad] in the first direction, and
is more than 5 [mrad] in the second direction.

**87.** The illumination optical apparatus according to claim 85,
wherein the field stop is located near the surface to be illuminated, or, on or near a plane conjugate with the surface to be illuminated.

**88.** The illumination optical apparatus according to claim 85,
wherein the shape of the illumination light applied onto the surface to be illuminated varies at least either in a width in the second direction, depending upon positions in the first direction, or in a width in the first direction, depending upon positions in the second direction.

**89.** The illumination optical apparatus according to any one of claims 85 to 88, comprising illumination light uniformizing means for substantially uniformizing an intensity distribution of the illumination light in the surface to be illuminated.

**90.** The illumination optical apparatus according to claim 89,
wherein the illumination light uniformizing means includes at least one fly's eye lens in which lens elements are arrayed along the specific direction.

91. The illumination optical apparatus according to claim 90,
wherein the illumination light uniformizing means comprises a condensing optical system for substantially limiting illumination light incident to an arbitrary lens element in said at least one fly's eye lens, to illumination light distributed in a predetermined range in the first direction, among illumination light distributed in a predetermined plane on the light source side of the fly's eye lens in the illumination light uniformizing means.

92. The illumination optical apparatus according to claim 90,
wherein the illumination light uniformizing means comprises secondary illuminant position correcting means for arraying a plurality of secondary light sources formed on an exit surface of said at least one fly's eye lens, substantially on a line parallel to the specific direction.

93. The illumination optical apparatus according to any one of claims 85 to 88, comprising a convergence/divergence adjusting mechanism for making variable a convergence/divergence state in the first direction of the illumination light applied into the surface to be illuminated.

94. The illumination optical apparatus according to any one of claims 85 to 88, comprising a polarization control member for defining a magnitude relation between a component of an electric field in the first direction and a component of the electric field in the second direction, of the illumination light applied onto the surface to be illuminated.

95. The illumination optical apparatus according to any one of claims 85 to 88, wherein a temporal coherence length of the illumination light is not more than 100 $\mu$m.

## *Fig.1*

*Fig.2*

(A)

(B)

# Fig.3

# Fig.4

# *Fig.5*

# Fig.6

(A)

IL10a
P1  G11  T1
LMa  LPa
L1
P2  T2  G21
LM1a  LP1a  L2
PR
W

(B)

IFap
ZP
IFa0
Z0
IFam
ZM
X0

Z
Y  X

(C)

IL10b  φ  VP
P1  G11  T1
LMb  LPb
L1
P2  T2  G21
LM1b  LP1b  L2
PR
W

(D)

IFbp  δp
ZP
IFb0
Z0
IFbm  δm
ZM
X0

# Fig.7

(A)

(B)

(C)

(D)

# *Fig.8*

(A)

(B)

(C)

# Fig.9

(A)

(B)

# Fig.10

(A)

CL

F1a
F2a
F3a
F4a
F5a
F6a
F7a
F8a

} 13a

Y

Z → X

(B)

CL

F1b
F2b
F3b
F4b
F5b
F6b
F7b
F8b

} 13b

Y

Z → X

# Fig.11

# Fig.12

40Y1  40Y2          40Y3

39Y

39X

40X1

40X2

41

W

38

43

44

35

42

Y

Z → X

## Fig.13

(A) 22 23a 23 23b

Y
Z ⊙ → X

(B) 22 24a 24b 24

# *Fig.14*

# Fig.15

(A)

IL10c    IL10d    IL10e

LEa

LEb

P1

(B)    ψe    ψe

IL10f    IL10g    IL10h

LEa

LEb

LEa1

LEb1

P1

Z

Y    X

## Fig.16

## Fig.17

# Fig.18

# *Fig.19*

*Fig.20*

# Fig.21

(A)

(B)

# Fig.22

(A)

(B)

| **INTERNATIONAL SEARCH REPORT** | International application No. |
|---|---|
| | PCT/JP2006/303333 |

A. CLASSIFICATION OF SUBJECT MATTER
***H01L21/027***(2006.01), ***G03F7/20***(2006.01)

According to International Patent Classification (IPC) or to both national classification and IPC

B. FIELDS SEARCHED

Minimum documentation searched (classification system followed by classification symbols)
***H01L21/027***(2006.01), ***G03F7/20***(2006.01)

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 5-188577 A (Nikon Corp.), 30 July, 1993 (30.07.93), page 1 & US 5703675 A1 | 1-84 |
| A | JP 5-326365 A (Nikon Corp.), 10 December, 1993 (10.12.93), Page 1; Fig. 2 & US 5703675 A1 | 1-84 |
| A | JP 8-316125 A (Hitachi, Ltd.), 29 November, 1996 (29.11.96), Page 1 (Family: none) | 1-84 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 22 May, 2006 (22.05.06) | 30 May, 2006 (30.05.06) |

| Name and mailing address of the ISA/ Japanese Patent Office | Authorized officer |
|---|---|
| Facsimile No. | Telephone No. |

Form PCT/ISA/210 (second sheet) (April 2005)

**INTERNATIONAL SEARCH REPORT**

International application No.

PCT/JP2006/303333

C (Continuation).   DOCUMENTS CONSIDERED TO BE RELEVANT

| Category* | Citation of document, with indication, where appropriate, of the relevant passages | Relevant to claim No. |
|---|---|---|
| A | JP 8-316124 A   (Hitachi,  Ltd.),<br>29 November,  1996  (29.11.96),<br>Page 1<br>& US 5715039 A1 | 1-84 |

Form PCT/ISA/210 (continuation of second sheet) (April 2005)

**INTERNATIONAL SEARCH REPORT**

International application No.

PCT/JP2006/303333

| Box No. II | Observations where certain claims were found unsearchable (Continuation of item 2 of first sheet) |
|---|---|

This international search report has not been established in respect of certain claims under Article 17(2)(a) for the following reasons:

1. ☐ Claims Nos.:

because they relate to subject matter not required to be searched by this Authority, namely:

2. ☐ Claims Nos.:

because they relate to parts of the international application that do not comply with the prescribed requirements to such an extent that no meaningful international search can be carried out, specifically:

3. ☐ Claims Nos.:

because they are dependent claims and are not drafted in accordance with the second and third sentences of Rule 6.4(a).

| Box No. III | Observations where unity of invention is lacking (Continuation of item 3 of first sheet) |
|---|---|

This International Searching Authority found multiple inventions in this international application, as follows:

Claims 85-95

The "special technical feature" of the invention in claims 1-84 is of irradiating a substrate with an interference pattern generated by a first diffraction grating and a second diffraction grating. The "special technical feature" of the invention in claims 85-95 does not have the above mentioned feature. Since these inventions do not have a technical relationship involving one or more of the same or corresponding special technical features, these inventions are not considered to be linked to form a single general inventive concept.

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1-84

**Remark on Protest** the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005052158 A

**Non-patent literature cited in the description**

- **J. M. CARTER et al.** *Interference Lithography, http://snl.mit.edu/project_document/SNL-8.pdf*

- **MARK L. SCHATTENBURG et al.** *Grating Production Methods, http://snl.mit.edu/papers/presentations/2002/MLS-Con-X-2002-07-03.pdf*